# EUROPEAN PATENT APPLICATION

(11) **EP 2 011 639 A1**
(43) Date of publication of application: **07.01.2009**
(21) Application number: 07741188.2
(22) Date of filing: 06.04.2007
(51) Int. Cl.: B32B 9/00

(54) **GAS BARRIER FILM, RESIN BASE FOR ORGANIC ELECTROLUMINESCENT DEVICE, ORGANIC ELECTROLUMINESCENT DEVICE USING THE SAME, AND METHOD FOR PRODUCING GAS BARRIER FILM**

(30) Priority: 21.04.2006 JP 2006117667
(71) Applicant: KONICA MINOLTA HOLDINGS, INC., Tokyo 100-0005 (JP)
(72) Inventor: FUKUDA, Kazuhiro, Hino-shi, Tokyo 191-8511 (JP); OZAKI, Koji, Hino-shi, Tokyo 191-8511 (JP); II, Hiromoto, Hino-shi, Tokyo 191-8511 (JP); ARITA, Hiroaki, Hino-shi, Tokyo 191-8511 (JP); SUZUKI, Issei, Hino-shi, Tokyo 191-8511 (JP)
(74) Representative: McCluskie, Gail Wilson
(86) International application number: PCT/JP2007/057752
(87) International publication number: WO 2007/123006

(57) **Abstract**

Disclosed is a gas barrier film which uses a polymerizable inorganic compound and has both high barrier property and high surface smoothness. Also disclosed are a resin base for organic electroluminescent devices using such a gas barrier film, an organic electroluminescent device and a method for producing a gas barrier film. The gas barrier film is **characterized by** comprising at least one ceramic film and a coating layer, which is formed through application of a coating liquid containing a polymerizable inorganic compound, on a resin film in this order. The gas barrier film is further **characterized in that** the ceramic film has a residual stress of not less than 0.01 MPa but not more than 20 MPa.

## Description

### TECHNICAL FIELD

The present invention relates to a gas barrier film, a resin base for organic electroluminescent device, an organic electroluminescent device using the bas barrier film and a method for producing the gas barrier film.

### TECHNICAL BACKGROUND

Hitherto, gas barrier films such as those produced by forming a thin layer of metal oxide such as aluminum oxide, magnesium oxide and silicon oxide on a plastic substrate of film are widely used as a packing material for materials requiring shut off from various gases such as water vapor and oxygen and that for preventing deterioration of foods and medicines. The gas barrier films are also used in liquid crystal displays, solar cells and organic electroluminescent devices, hereinafter also referred to as organic EL devices, other than the use as the packing materials.

Aluminum foil is widely used as a packing material in such the field. However, the aluminum foil causes a problem of disposal and that the foil is basically opaque so that the wrapped content cannot be confirmed from the outside. Moreover, the foil cannot be applied at all for the displaying devices requiring transparency.

Application of film materials such as those of a transparent resin for the liquid crystal displaying devices and the organic EL devices is started according to requirements of weight reduction, large sizing, durability for prolonged period and high freedom in the form in stead of glass substrates which are heavy, fragile and difficult in large sizing. Examples of application of polymer film as the substrate of organic electroluminescent device are disclosed in Tokkai Hei 2-251429 and 6-124785.

However, there is a problem that the film substrate such as transparent plastics is inferior to glass in the gas barrier property. For example, when a substrate inferior in the gas barrier property is used for the organic electroluminescent device, lowering in the light emission property and the durability are caused by deterioration of the organic layer caused by oxygen penetrated through the substrate. Moreover, problems of deterioration of the device and that the vacuum required in the electronic device cannot be held are caused by oxygen penetrated through the substrate and diffused in the device when a polymer substrate is used as the substrate of electronic device.

It has been known for solving such the problems that a film substrate on which a metal oxide thin layer is formed is used as the gas barrier film substrate. As the gas barrier film to be used for the packing material or the liquid crystal displaying device, a plastic film on which silicon oxide is vapor deposited, cf. Patent Publication 1, and that on which aluminum oxide is vapor deposited, cf. Patent Publication 2, are known. It is present status that the above films each have only a water vapor barring ability of about 2 g/m²·day and an oxygen permeability of about 2 ml/m²·day·atm.

Recently, the requirement on the gas barrier ability is raised to a level of water vapor permeability of 1 x 10⁻³ g/m²·day according to development of organic El displays requiring higher gas barrier ability and large sized liquid crystal displays and high definition displays.

As a method for responding to such the high water vapor insulating ability, a gas barrier film in which dense ceramic layers and polymer layers capable of easing shocks from outside are alternatively and repeatedly laminated is proposed; cf. Patent Publication 3 for. However, the adhesiveness at the contacting interface of the ceramic layer and the polymer layer is lowered so as to tend to cause the quality degradation such as peeling between the layers since the compositions of these layers are generally different from each other. The degradation in the adhesiveness is considerably caused when the film is stood under severe conditions such as high temperature and high humidity or irradiated by UV for a prolonged period. Thus quickly improvement is demanded. The smoothness of the surface of the barrier film can be improved by providing a flexible organic polymer layer as the outermost layer of the film; cf. Non-patent Publication 1. However, when the organic layer is provided on the ceramic barrier layer and a transparency electroconductive layer is directly provided on that, any high transparent electroconductive layer cannot be obtained by gas component formed from the organic layer.

Moreover, it is understood that the ceramic layer may not merely a ceramic layer and should be one which has high density and is difficultly breakable and certain properties is required to the resin film for the substrate.

Besides, it is necessary to provide a transparent electrode on the barrier film in the organic electroluminescent device formed on such the substrate. Particularly in a surface light emission device necessarily have relatively large area such as backlights or lighting devices, a film having low electric resistivity, excellent transparency and further high smoothness is required.

A surface smoothness of not more than 1 nm in the center-line average roughness and not more than 10 nm in the bottom/peak height are required. It is necessary to attain the surface smoothness of the resin film itself. However, the meaning of the smoothness of the resin film itself is lost when the smoothness is degraded in the barrier layer forming process even if the smoothness of the resin film is sufficiently attained.

It is difficult to make zero the projection in a relatively large area by vapor deposition, sputtering of CDV method though only about sufficient smoothness can be obtained by smoothing the substrate.
Patent Publication 1: Tokko Sho 53-12953
Patent Publication 2: Tokkai Sho 58-217344
Patent Publication 3: U.S.P. No. 6,268,695
Non-patent Publication 1: Thin Solid Films 308-309, (1977) 19-25

### DISCLOSURE OF THE INVENTION

### PROBLEMS TO BE SOLVED BY THE INVENTION

The invention is attained based on the above background and objects of the invention are to provide a gas barrier film having both of high barrier ability and surface smoothness, a resin base for organic electroluminescent device using the barrier film, an organic electroluminescent device and a method for producing the gas barrier film.

### MEANS FOR SOLVING THE PROBLEMS

The above objects of the invention can be attained by the following constitution.
1. A gas barrier film comprising a resin film, and a ceramic layer and a coated layer formed by coating a coating liquid containing a polymerizable inorganic compound each provided on the resin film in this order and the remaining stress in the ceramic layer is within the of from 0.01 MPa to 20 MPa.
2. The gas barrier film described in 1, in which the coated layer is placed at the outermost position.
3. The gas barrier film described in 1 or 2, in which the substance constituting the ceramic layer is one selected from the group consisting of silicon oxide, silicon oxide nitride, silicon nitride, aluminum oxide and a mixture thereof.
4. The gas barrier film described in any one of 1 to 3, in which the polymerizable inorganic compound is silica sol or alumina sol.
5. The gas barrier film described in any one of 1 to 4, in which the smoothness of the coated layer is not more than 1 nm in center-average roughness.
6. A resin base for an organic electroluminescence comprising a transparent electrode formed on the gas barrier film described in any one of 1 to 5.
7. An organic electroluminescent device in which a phosphorescent light emitting electroluminescent material and a metal layer to be a cathode are coated on the resin base for organic electroluminescence described in 6 and a resin-laminated metal foil is further pasted thereon for sealing.
8. The organic electroluminescent device described in 7, in which the resin laminated metal foil is a metal foil laminated by a resin on the side not to be contacted with the cathode and coated by a ceramic layer on the side to be contacted with the cathode.
9. A method for producing the gas barrier film comprising a resin film and a ceramic layer and a coated layer each provided on the resin film in this order, in which the ceramic layer is formed by a thin layer forming method in which gas containing a thin layer forming gas is supplied into an electric discharging space under atmospheric or near atmospheric pressure, and high frequency electric field is applied to the electric discharging space for exiting the gas, and then the substrate is exposed to the excited gas; and the coated layer is formed by coating a coating liquid containing an inorganic polymerizable compound.
10. The method for producing the gas barrier film described in 9, in which the water vapor permeability of the gas barrier film measured at 25 ± 0.5 °C and 90 ± 2% RH according to JIS K 7129-1992 is not more than 1 x 10⁻⁴ g/(m²·24h) and the oxygen permeability of that measured according to JIS K 7126-1987 is not more than 1 x 10⁻⁴ ml/( m²·24h·atm).
11. The method for producing the gas barrier film described in 9 or 10, in which the coated layer is placed at the outermost portion.
12. The method for producing the gas barrier film described in any one of 9 to 11, in which the remaining stress in the ceramic layer is within the range of from 0.01 MPa to 20 MPa.
13. The method for producing the gas barrier film described in any one of 9 or 12, in which the material constituting the ceramic layer is one selected from the group consisting of silicon oxide, silicon oxide nitride, silicon nitride, aluminum oxide and a mixture thereof.
14. The method for producing the gas barrier film described in any one of 9 or 13, in which the polymerizable inorganic compound is silica sol of alumina sol,
15. The method for producing the gas barrier film described in any one of 9 or 14, in which the surface roughness of the coated layer is not more than 1 nm in the center-line average roughness.

### EFFECTS OF THE INVENTION

The gas barrier film which has both of high barrier ability and surface smoothness, the resin base for organic electroluminescence using the gas barrier film, the organic electroluminescent device and the method for producing the gas barrier film can be provided by the invention.

### BRIEF DESCRIPTION OF THE DRAWINGS

Fig. 1 shows a graph of the relation between the remaining stress in a silicon oxide layer formed by vacuum vapor deposition and the vacuum degree.
Fig. 2 is a schematic drawing of an example of jet type atmospheric pressure plasma discharging treatment apparatus applicable in the invention.
Fig. 3 is a schematic drawing of an example of atmospheric pressure plasma discharging treatment apparatus applicable in the invention, in which the substrate is treated between facing electrodes.
Fig. 4 is a perspective view of an example of structure of the electroconductive metallic mother member of the rotatable roller electrode shown in Fig. 3 and the dielectric material covering the metallic mother member.
Fig. 5 is a perspective view of an example of structure of the electroconductive mother member of square columnar electrode and the dielectric material covering the electrode mother member.
Fig. 6 is a schematic drawing of layer structure of the gas barrier film of the invention.
Fig. 7 is a schematic drawing of the cross section of an organic EL device sealed by the gas barrier film of the invention.
Fig. 8 is a schematic drawing showing an example of display constituted by an organic EL device.
Fig. 9 is a schematic drawing of the displaying portion A.
Fig. 10 is a schematic drawing of pixels.
Fig. 11 is a schematic drawing of a passive matrix type display.

### DESCRIPTION OF SYMBOLS

- 1,: 2: Gas barrier film
- 3:: Ceramic layer
- H:: Smoothed layer
- Y:: Resin film substrate
- 10,: 30: Plasma discharging treatment apparatus
- 11:: First electrode
- 12:: Second electrode
- 14:: Treatment position
- 21,: 41: First power source
- 22,: 42: Second power source
- 32:: Discharging space (between facing electrodes)
- 35:: Rotatable roller electrode
- 35a:: Roller electrode
- 35A:: Metallic mother member
- 35B,: 36B: Dielectric material
- 36:: Square columnar fixed electrode group
- 36a:: Square columnar electrode
- 36A:: metallic mother member
- 40:: Electric field applying means
- 50:: Gas supplying means
- 52:: Gas supplying opening
- 53:: Gas exhausting opening
- F:: Substrate
- G:: Gas
- G°:: Gas in plasma state

### PREFERRED EMBODIMENT OF THE INVENTION

The best embodiment for embodying the invention is described in detail below.

As a result of investigation by the inventors, it is found that the gas barrier film having both of high barrier ability and surface smoothness can be realized by a gas barrier film comprising a gas barrier film and a ceramic layer and a coated layer each formed on the gas barrier film in this order, in which the coated layer is formed by coating a coating liquid containing a polymerizable inorganic compound and the remaining stress in the ceramic layer is within the range of from 0.01 to 20 MPa. Thus the invention is attained.

The invention is described in detail below.

### <<Gas barrier film>>

In the gas barrier film of the invention, a ceramic layer having low remaining stress and high density is coated on the resin film substrate so as to obtain a gas barrier film having high gas barrier ability even when ceramic layers is not repeatedly laminated on the resin film as in usual gas barrier film.

The gas barrier film of the invention is a laminated film having a ceramic layer formed on the resin film, and the ceramic layer has a compression stress of from 0.01 to 20 MPa. The film having high durability and excellent gas barrier ability can be obtained by forming such the dense layer.

The gas barrier ability of the gas barrier film of the invention is preferably not more than 1 x 10⁻⁴ g/(m²·24h) in the water vapor permeability measured according to JIS K 7129-1992 at 25 ± 0.5 °C and 90 ± 2% RH and not more than 1 x 10⁻⁴ ml/( m²·24h·atm) in the oxygen permeability measured according to JIS K 7126-1987 since growing dark spots are formed if water vapor permeation occurs slightly. S a result of that the displaying lifetime of the display is very shortened sometimes when the barrier film is used in the organic EL device.

### (Ceramic layer)

The composition of the ceramic layer relating to the invention is not limited in as long as the layer has the above remaining stress and is capable of preventing the permeation of oxygen and water vapor. As the material constituting the ceramic layer relating to the invention, inorganic compounds are preferable in concrete and a ceramic layer of silicon oxide, aluminum oxide, silicon oxide nitride, aluminum oxide nitride, magnesium oxide, zinc oxide, indium oxide or tin oxide is cited.

The remaining stress in the ceramic layer formed on the resin film is a compression stress of from 0.01 MPa to 20 MPa.

The resin film having a ceramic layer formed by, for example, vapor deposition, CVD method or sol-gel method is curved in plus or minus direction according to the relation between the substrate film and the property of the ceramic layer when the film is stood under a certain condition. The curling is caused by the stress generated in the ceramic layer and it is considered that larger curing (plus curing) corresponding to higher compression stress.

The interior stress in the ceramic layer is measured by the following method.

A ceramic layer the same as the layer to be measured in the composition and thickness is formed in the same manner on a quartz substrate of a width of 10 mm, a length of 50 mm and a thickness of 0.1 mm. The prepared sample is set on a thin layer property evaluation apparatus MH4000, manufactured by NEC San-ei Co., Ltd., so that the concave side of the sample is toward upside and the curling value is measured. Generally, the stress is expressed by plus stress when the curling is plus curl caused by shrinking the layer side by the compressing stress and is expressed by minus stress when the curling is minus curl caused by tensile stress.

In the invention, the stress is necessarily not more than 20 MPa and within the range of from 0.01 MPa to 20 MPa.

The remaining stress of the film on which the silicon oxide layer is formed can be controlled by controlling the vacuum degree on the occasion of forming the silicon oxide layer by vacuum deposition.

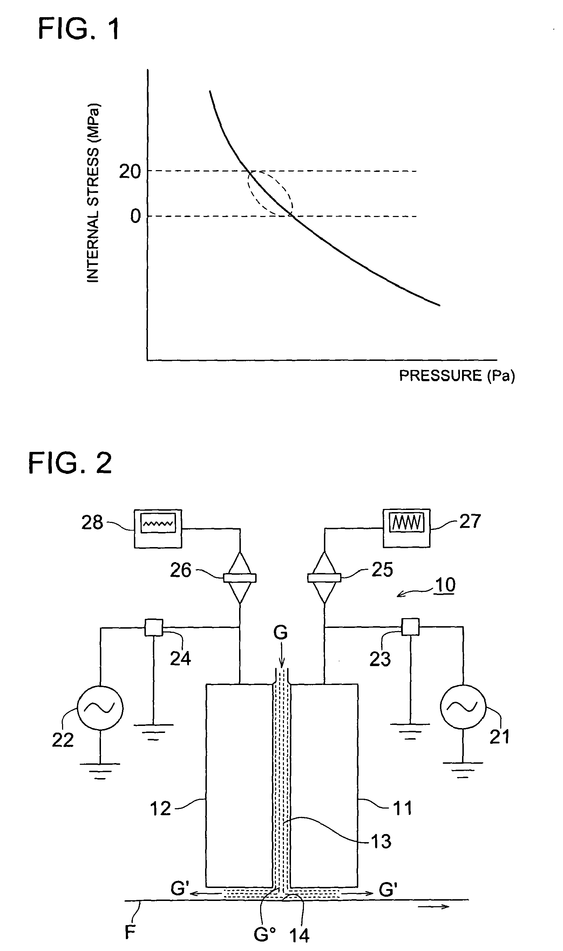

Fig. 1 shows the relation between the vacuum degree in the vessel and the remaining (interior) stress in the silicon oxide layer measured by the foregoing method when the silicon oxide layer of 1 µm is formed by vacuum deposition method on the quartz substrate having a width of 10 mm, a length of 50 mm and a thickness of 0.1 mm. The laminated film having a remaining stress of not less than 0 and not more than about 20 MPa is preferable. When the stress is too low, the stress is partially becomes tensile stress in some cases, cracks and breaking are easily caused in the layer so that durability of the layer is lost, and the layer is made brittle when the stress is excessively high.

The ceramic layer having high density and high barrier ability can be difficultly formed by a wetting method such as sol-gel method.

In the invention, the ceramic layer is preferably formed by a sputtering method, an ion assisting method, the later-mentioned plasma CVD method carried out under the atmospheric pressure though the producing method of the ceramic layer as the gas barrier layer is not specifically limited. The atmospheric pressure plasma CVD method is preferable because high speed layer formation can be carried out without necessity of any vacuum vessel and high production efficiency can be obtained by this method. Moreover, the uniform layer having high smoothness and lowered interior stress (within the range of from 0.01 to 20 Mpa) can be relatively easily formed by the atmospheric pressure plasma CVD method.

The thickness of the ceramic layer in the invention is preferably within the range of from 1 to 2,000 nm though the optimum condition of the thickness is varied depending on the kind and composition of the material and is suitably selected.

When the thickness of the gas barrier layer is 1 nm or more, the uniform layer and the barrier ability against the gas can be obtained. When the thickness is not more than 2,000 nm, the gas barrier film can hold flexibility and resistivity against external factors such as bending and stretching after formation of the film.

When the thickness is lower than the above range, defects of the layer is increased so that sufficient moistureproof ability cannot be obtained. Thicker layer has theoretically higher moistureproof ability but excessively large thickness of the layer unnecessarily causes high interior stress so that the layer is easily broken and the moistureproof ability cannot be obtained.

In the invention, the ceramic layer for forming the gas barrier layer is preferably transparent. When the ceramic layer is transparent, the gas barrier film can be made transparent so that the gas barrier film can be used as the transparent substrate of the organic EL device. For example, the light transmission of the gas barrier film at a wavelength of 550 nm is preferably not less than 80% and more preferably not more than 90%.

The plasma CVD method or that performed under the atmospheric or near atmospheric pressure is preferable because the ceramic layer of metal carbide, metal nitride, metal oxide, metal sulfide, or a mixture such as metal oxide nitride and metal nitride carbide can be separately formed as the gas barrier layer by selecting the conditions such as organic metal compound as a raw material, decomposition gas, decomposition temperature and applied electric power.

For example, silicon oxide is formed by using a silicon compound as the raw material compound and oxygen as the decomposition gas. Zinc sulfide is formed by using a zinc compound as the raw material compound and carbon disulfide as the decomposition gas. Such the reaction can be carried out because extremely active charged particles and active radicals exist at high density in the plasma space so that plural steps of chemical reaction are progressed at very high rate and the elements being in the plasma space are converted at very high rate into a thermodynamically stable compound.

The raw material of the inorganic compound may be gas, liquid or solid under ordinary temperature and pressure as long as the compound has a typical or transition metal element. The raw material can be directly introduced into the discharging space when the material is gas. When the raw material is liquid or solid, the material is vaporized for used by suitable means such as heating, bubbling, pressure reducing and ultrasonic wave irradiation. The material may be used in a dissolved state in a solvent, an organic solvent such as methanol, ethanol and n-hexane and a mixture thereof is usable as the solvent. Such the diluting solvent is decomposed into molecular or atomic state in the plasma discharging treatment; therefore, influence of the solvent can be practically ignored.

As the organic metal compound the followings are cited. Examples of the silicon compound include silane, tetramethoxysilane, tetraethoxysilane (TEOS), tetra-n-propoxysilane, tetraisopropoxysilane, tetra-n-butoxysilane, tetra-t-butoxysilane, dimethyldimethoxysilane, dimethyldiethoxysilane, diethyldimethoxysilane, diphenyldimethoxysilane, methyltriethoxysilane, ethyltrimethoxysilane, phenyltriethoxysilane, (3,3,3-trifluoropropyl)-trimethoxsilane, hexamethyldisiloxane, bis(dimethylamino)-dimethylsilane, bis(dimethylamino)methylvinylsilane, bis(ethylamino)dimethylsilane, N,O-bis(trimethylsilyl)-carbodimide, bis(trimethylsilyl)carbodimide, diethylaminotrimethylsilane, dimethylaminodimethylsilane, hexamethyldisilane, hexamethylcyclotrisilane, heptamethyldisilane, nanomethyltrisilazane, octamethylcyclotetrasilazane, tetrakisdimethylaminosilane, tetraisocyanatesilane, tetramethylsilazane, tolyltrimethylsilane, benzyltrimethylsilane, bis(trimethylsilyl)acetylene, 1,4-bistrimethylsilyl-1,3-butadiine, di-t-butylsilane, 1,3-disilabutane, bis(trimethylsilyl)methane, cyclopentadienyltrimethylsilane, phenyldimethylsilane, phenyltrimethylsilane, propalgyltrimethylsilane, tetramethylsilane, trimethylsilylacetylene, 1-(trimethylsilyl)-1-propine, tris(trimethylsilyl)methane, tris(trimethylsilyl)silane, vinyltrimethylsilane, hexamethyldisilane, octamethylcyclotetrasiloxane, tetramethylcyclotetrasiloxane, hexamethylcyclotetrasilxane and M Silicate 51.

Examples of titanium compound include titanium methoxide, titanium ethoxide, titanium isopropoxide, titanium tetraisopropoxide, titanium n-propoxide, titanium diisopropoxide(bis-2,4-pentanedionate), titanium diisoproxide(bis-2,4-ethylacetoacetate), titanium di-n-butoxide(bis-2,4-pentanedionate), titanium acetylacetonate and butyltitanate dimer.

Examples of zirconium compound include zirconium n-propoxide, zirconium n-butoxide, zirconium t-butoxide, zirconium tri-n-butoxideacetylacetonate, zirconium di-n-butoxidebisacetyacetonate, zirconium caetylacetonate, zirconium acetate and zirconium hexafluoropentanedionate.

Examples of aluminum compound include aluminum ethoxide, aluminum triisoproxide, aluminum isopropoxide, aluminum n-butoxide, aluminum s-butoxide, aluminum t-butoxide, aluminum acetylacetonate and triethyldialuminum-tri-s-butoxide.

Examples of boron compound include diborane, tetraborane fluoride, boron chloride, boron bromide, borane-diethyl ether complex, borane-THF complex, borane-dimethylsulfide complex, boron trifluoride-diethyle ether complex, triethylborane, trimethoxborane, triethoxborane, tri(isopropoxy)borane, borazole, trimethylborazole, triethylborazole and triisopropylborazole.

Examples of tin compound include tetraethyl tin, tetramethyl tin, di-n-butyl tin diacetate, tetrabutyl tin, tetraoctyl tin, tetraethoxy tin, methyltriethoxy tin, diethyldiethoxy tin, triisopropylethoxy tin, diethyl tin, dimetyl tin, diisopropyl tin, dibutyl tin, diethoxy tin, dimethoxy tin, diiopropoxy tin, dibutoxy tin, tin dibutylate, tin diacetocetonate, ethyl tin acetoacetonate, ethoxy tin acetoacetonate, dimethyl tin diacetoacetonate, a tin hydrogen compound and a tin halide such as tin dichloride and tin tetrachloride.

Examples of another organic metal compound include antimony ethoxide, arsenic triethoxide, barium 2,2,6,6-tetramethylheptanedionate, beryllium acetylacetonate, bismuth hexafluoropentanedionate, dimethyl cadmium, calcium 2,2,6,6-tetramethylheptanedionate, chromium trifluoropentanedionate, copper hexafluoropentanedionate, magnesium hexafluoropentanedionate-dimetylether complex, gallium ethoxide, tetraethoxy germanium, tetramethoxy germanium, hafnium t-butoxide, hafnium ethoxide, indium acetylacetonate, indium 2,6-dimethylaminoheptanedionate, ferrocene, lanthanum isopropoxide, lead acetate, tetraethyl lead, neodium acetylacetonate, platinum hexafluoropentanedionate, triethylcyclopentadienyl platinum, rhodium dicarbonylacetylacetonate, strontium 2,2,6,6-tetramethylheptanedionate, tantalum methoxide, tantalum trifluoroethoxide, tellurium ethoxide, tungsten ethoxide, vanadium triisopropoxide, magnesium hexafluoroacetylacetonate, zinc acetylacetonate and diethyl zinc.

As the decomposition gas or obtaining inorganic compound by decomposing the metal-containing raw material gas, hydrogen gas, methane gas, acetylene gas, carbon monoxide gas, carbon dioxide gas, nitrogen gas, ammonia gas, dinitrogen monoxide gas, nitrogen oxide gas, nitrogen dioxide gas, oxygen gas, water vapor, fluorine gas, hydrogen fluoride, trifluoroalcohol, trifluorotoluene, hydrogen sulfide, sulfur dioxide, carbon disulfide and chlorine gas are cited for example.

Various kinds of metal carbide, metal nitride, metal oxide, metal halide and metal sulfide can be obtained by suitably selecting the metal containing raw material gas and the decomposition gas.

These reactive gases are mixed in a discharging gas capable of easily being into a plasma state and sent into the plasma discharge generating apparatus.

As such the discharging gas, nitrogen gas and/or an atom of Group 18 of periodic table, concretely, helium, argon, krypton, xenon and radon are used. Among them, nitrogen, helium and argon are preferably used and nitrogen which is low in the cast is more preferable.

The discharging gas and the reactive gases are supplied in a state of a mixed gas to the plasma discharge generating apparatus (plasma generating apparatus to form the layer. The content of the discharging gas is made 50% or more of the entire mixed gas to be supplied though the ratio of the discharging gas and the reactive gas may be varied according to the property of the layer to be formed.

In the ceramic layer to be used as the gas barrier layer of the invention, the inorganic compound contained in the layer is preferably SiOₓC_{y} (x = 1.5 to 2.0 and y = 0 to 0.5) or SiOₓ, SiN_{y} or SiOₓN_{y} (x = 1 to 2 and y = 0.1 to 1) and SiOₓ is particularly preferable from the viewpoint of the gas barrier ability, moisture permeability, light transparency and suitability for the later-mentioned atmospheric pressure plasma CVD.

The ceramic layer of the invention which contains silicon atoms and at least one kind of oxygen atoms and nitrogen atoms can be obtained by the use of the above organic silicon compound combined with oxygen gas or nitrogen gas in a designated ratio.

As above-mentioned, various kinds of inorganic layer can be formed by using the above raw material gas with the discharging gas.

### (Coated layer formed by coating a coating liquid containing polymerizable inorganic compound)

The layer to be provided onto the side of the ceramic layer opposite to the side facing to the resin film, hereinafter referred to as the coated layer, is described below. The coated layer of the invention is preferably the outermost layer of the gas barrier layer since the coated layer has a function of a smoothing layer.

The polymerizable inorganic compound to be used for forming the coated layer is described below.

The polymerizable inorganic compound may be photopolymerizable or thermally polymerizable and is preferably photopolymerizable. As the polymerizable inorganic compound, a compound formed by SiO₂ sol and a reactive organic silicon compound and a compound formed by alumina sol and a reactive organic aluminum compound are preferable. The compounds described in Tokkai Hei 7-126552, 7-188582, 8-100136, 9-220791 and 9-272169 are particularly preferred.

The inorganic compound preferably usable in the invention is a compound formed from SiO₂ sol and the reactive organic silicon compound. The surface smoothing layer of SiO₂ gel is formed by the use of a sol liquid containing the SiO₂ sol and the reactive organic silicon compound. The SiO₂ sol is prepared by dissolving silicon alkoxide in an organic solvent suitable for coating and adding a certain amount of water to hydrolyze the silicon alkoxide.

Preferable example of silicon alkoxide to be used for forming the SiO₂ sol is represented by the following Formula I.

Formula I (R')ᵣSi(OR")ₛ

In the above, R' and R" are each an alkyl group having 1 to 10 carbon atoms, which may be the same as or different from each other and r and s are each an integer and r + s is 4. Concretely, tetramethoxysilane, tetraethoxysilane, tetraisopropoxysilane, tetra-n-propoxysilane, tetra-n-butoxysilane, tetra-sec-butoxysilane, tetra-t-butoxysilane, tetrapentaethoxysilane, tetrapentaisopropoxysilane, tetrapenta-n-propoxysilane, tetrapenta-n-butoxysilane, tetrapenta-sec-butoxysilane, tetrapenta-t-butoxysilane, methyltrimethoxysilane, methyltriethoxysilane, methyltripropoxysilane, methyltributoxysilane, dimethyldimethoxysilane, dimethyldiethoxysilane, dimethylmethoxysilane, dimethylethoxysilane, dimethylpropoxysilane, dimethylbutoxysilane, methyldimethoxysilane, methyldiethoxysilane and hexyltrimethoxysilane are cited.

The SiO₂ sol can be prepared by dissolving the above alkyl silicon alkoxide or the silicon alkoxide in a suitable solvent. Examples of the solvent to be used include alcohols, ketones and esters such as methyl ethyl ketone, isopropyl alcohol, methanol, ethanol, methyl isobutyl ketone, ethyl acetate and butyl acetate, halogenized hydrocarbons, and aromatic hydrocarbons such as toluene and xylene. The alkyl silicon alkoxide or silicon alkoxide is dissolved in the above solvent so that the concentration of that is to be not less than 0.1%, and preferably from 0.1% to 10%, by weight in terms of the amount of SiO₂ formed by completely hydrolysis and condensation. When the concentration of SiO₂ sol is not less than 0.1%, the sol layer formed by that can sufficiently give required properties and when the concentration is not more than 10%, the transparent and uniform layer can be formed. In the invention, organic of inorganic binder can be used when the solid content is within the above range.

Water in an amount necessary for hydrolysis or more is added to the solution and stirred at a temperature of from 15 to 35 °C, preferably from 22 to 28 °C for a time of from 0.5 to 10 hours, preferably from 2 to 5 hours. A catalyst is preferably used for the hydrolysis. As the catalyst, an acid such as hydrochloric acid, nitric acid, sulfuric acid and acetic acid is preferable. The acid is added in a state of an aqueous solution of 0.001 to 20.0 moles/L, preferably 0.005 to 5.0 moles/L, and the water in the aqueous solution can be applied as water for the hydrlysis.

In the invention, a strong layer is formed by crosslinking with SiO₂ by the use of the reactive organic silicon compound, and thus obtained SiO₂ sol is a transparent and stable liquid having a pot life of about 1 month. The SiO₂ sol has high wettability with the substrate and shows superior coating suitability.

As the reactive organic silicon compound other than the foregoing reactive organic silicon compounds, an organic reactive compound having a molecular weight of not more than 3,000 and plural groups capable of crosslinking by heat or ionizing radiation (actinic energy ray reactive group) such as polymerizable double bond groups is preferable. Examples of such the reactive organic silicon compound include a polysilane having a functional vinyl group at one terminal position, a polysilane having functional vinyl groups at both of the terminals, a vinyl-functional polysilane or vinyl-functional polysiloxane formed by reaction of the above compounds, and the following compounds;

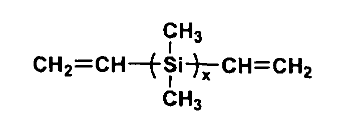

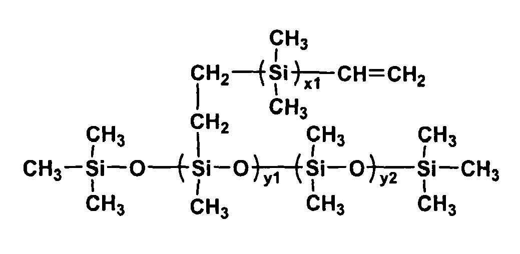

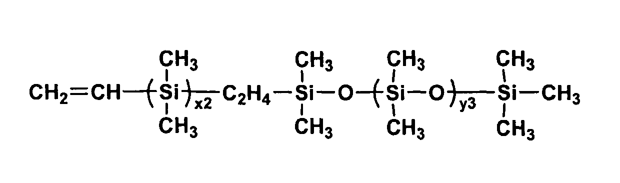

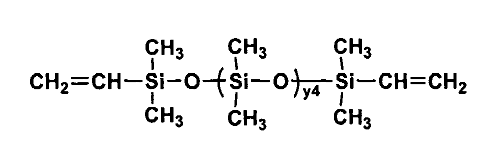

**In the above, x, x1, x2, y1, y2, y3 and y4 are each polymerization degree (addition number) of from 1 to 100**

Other than the above, vinyltrimethoxysilane, vinyltri (β-methoxy-ethoxy) silane, divinyloxysilane, β-(3,4-epoxycyclohexyl)-ethyltrialkoxysilane, acryloyloxy-ethyltriethoxysilane, glycidyloxyethyltriethoxysilane, γ-acryloyloxy-n-propyltri-n-propylsilane, γ-methacroyloxy-n-propyltri-n-propylsilane, di(γ-acryloyloxy-n-propyl)-di-n-propylsilane and acryloyloxydimethoxyethylsilane can be cited.

The reactive organic silicon compound such as those above-described is preferably used in a ratio of about 0.1 to 50 parts by weight to 100 parts by weight of SiO₂ sol (solid content).

Various additives can be added to the sol solution. A hardener accelerating the layer formation is used as the additive. As the hardener, a solution of organic metal salt such as sodium acetate and lithium acetate dissolved in an organic acid such as acetic acid and formic acid. The concentration of the metal salt in the organic acid is about 0.01 to 0.1% by weight, and the adding amount of the organic acid solution containing the organic metal salt is about from 0.1 to 1 part by weight based on the weight of SiO₂ contained in the sol solution.

The finally obtained gel layer (coated layer) is utilized as the surface smoothing layer of the gas barrier film. It is desirable to make smaller the size of sol for raising the smoothness and the size is preferably not more than 5 nm and more preferably not more than 3 nm.

The epoxy type actinic energy radiation reactive compound of the invention to be contained in the surface smoothing layer which contains a substance selected from the compounds formed by the above sol and the reactive organic compound is described below.

The surface smoothing layer which is very thin coated layer is insufficient in the hardness and weak to scratching. In such the case, an ethylenic unsaturated compound capable of crosslinking by actinic energy radiation easily for forming a hardened layer is generally added to the layer. However, sufficiently strengthen layer cannot be obtained by such the method because the crosslinkable ethylenic unsaturated compound is easily influenced by oxygen in air and polymerization of the ethylenic unsaturated compound tends to be inhibited since the layer is thin.

The coated layer of the invention is insufficient in the hardness so that the surface layer is weak to scratching. Therefore, it is preferable to add the epoxy type actinic energy radiation reactive compound and irradiate actinic energy radiation to form a coated layer having high hardness and strengthen against scratching. The epoxy type actinic energy radiation reactive compound is a superior actinic energy radiation reactive compound because it is difficultly influenced by oxygen; therefore, it is rapidly polymerized and can forms the layer having sufficient hardness and strength even when the thickness of the layer is about from 50 to 200 nm.

The epoxy type actinic energy radiation reactive compound is a compound having two or more epoxy groups in the molecule thereof and is capable of releasing a cation as a polymerization initiator by irradiation of the actinic energy radiation.

The epoxy type actinic energy radiation reactive compounds effectively usable in the invention are as follows:
(A) Glycidyl ether of bis-phenol A which is obtained by reaction of epichlorohydrin and bis-phenol A in a state a mixture of the compounds each different in the polymerization degree
(B) A compound having a glycidyl ether group at the terminal formed by reaction of a compound having two phenolic OH group such as bis-phenol A with epichlorohydrin, ethylene oxide and/ or propylene oxide
(C) Glycidyl ether of 4,4'-methylenebis phenol
(D) An epoxy compound of phenol-aldehyde resin of cresol resin or novolac resin
(E) A compound having alicyclic epoxide such as bis(3,4-epoxycyclohexylmethyl) oxalate, bis(3,4-epoxycyclohexylmethyl) adipate, bis(3,4-epoxy-6-cyclohexylmethyl) adipate, bis(3,4-epoxycyclohexyl)methyl pimelate, 3,4-epoxycyclohexylmethyl 3',4'-epoxycyclohexanecarboxylate,3,4-epoxy-1-methylcyclohexylmethyl-3',4'-epoxycyclohexanecarboxylate, 3,4-epoxy-1-methylcyclohexylmethyl-3',4'-epoxy-1'-metylcyclohexanecarboxylaate, 3,4-epoxy-6-methyl-cyclohexylmethyl3',4'-epoxy-6'-methyl-1'-cyclohexanecarboxylate and 2-(3,4-epoxycyclohexyl-5',5'-spyro-3",4"-epoxy)-cyclohexane-metadioxane
(F) A glycidyl ether of di-basic acid such as diglycidyl oxalate, diglycidyl adipate, diglycidyl tetrahysrophthalate, diglycidyl hexahydrophthalate and diglycidyl phthalate
(G) A glycidyl ether of glycol such as ethyleneglycol diglycidyl ether, diethyleneglycol digrycidyl ether, propyleneglycol diglycidyl ether, polyethyleneglycol diglycidyl ether, polypropyleneglycol diglycidyl ether, copoly(ethyleneglycol-propyleneglycol) diglycidyl ether, 1,4-butanediol diglycidyl ether and 1,6-hexanediol diglycidyl ether
(H) A glycidyl ester of polymeric acid such as polyglycidyl polyacrylate and diglycidyl ester of polyester;
(I) A glycidyl ether of polyhydric alcohol such as glycelol triglycidyl ether, trimethylolpropane triglycidyl ether, pentaerythrytol diglycidyl ether, pentaerythrytol triglycidyl ether, pentaerythrytol teraglycidyl ether and glucose triglycidyl ether

When the above epoxy compounds are cured by the actinic energy radiation, the mixing use of the compound having poly-functional epoxy groups of (H) or (I) is useful for further raising the hardness.

The photopolymerization initiator or optical sensitizer for cationic polymerizing the epoxy type actinic radiation reactive compound is a compound capable of releasing a cation polymerization initiation substance by irradiation of the actinic energy radiation, and is particularly a group of double salt of onium capable of releasing a Luis acid having initiation ability by the irradiation.

In the gas barrier film of the invention, it is one of the peculiarities that the coated layer (smoothing layer) of the invention is formed by coating a coating liquid containing the fore going polymerizable inorganic compound.

The coating method for forming the coated layer of the invention may be a method capable of stably forming the coating liquid into a uniform layer without any limitation. For example, a dip coat method, blade coat method, air knife coat method, wire bar coat method, gravure coat method, reverse coat method, extrusion coat method, slide coat method, curtain coat method and extrusion coat method carried out at a portion not supported by any back roller are applicable.

The center-line average roughness of the surface opposite to the ceramic layer side, namely the upper side, among the two sides of the coated layer is preferably 1 nm.

The leveling is desirably accelerated for smoothing the center-line average roughness Ra until a level of not more than 1 nm, and the surface tension of not more than 30 N/m and a viscosity of not more than 3 mPa·sec are desirable.

### (Resin film)

The resin film, also referred to as substrate, to be used in the transparent gas barrier film of the invention is described below.

The substrate is not specifically limited as long as the substrate is a film composed of an organic material capable of supporting the gas barrier layer having gas barrier ability.

The resin substrate is preferably transparent. The transparent gas barrier film can be obtained by that both of the substrate and the layer formed on the substrate are transparent. Thus the gas barrier film can be used as the transparent substrate of the organic EL device.

The resin film substrate using the foregoing resin may be a non-stretched or stretched film.

The resin film substrate to be used in the invention can be produced by usually known method. For example, a non-stretched substrate which is substantially amorphous and not oriented can be produced by that the raw material resin is melted in an extruder and extruded trough a circular or T-shaped die and rapidly cooled. A stretched substrate can be produced by stretching the non-stretched substrate by a known method such as mono-axial stretching, tenter type successive biaxial stretching, tenter type simultaneous biaxial stretching and tubular type simultaneous biaxial stretching in the flowing direction (longitudinal direction) or the direction making right angle with the flowing direction (lateral direction). In such the case, the stretching ratio is preferably from 2 to 10 times in the longitudinal direction and in the lateral direction, respectively, though the ratio can be suitably selected according to the raw material resin.

The resin film relating to the invention may be subjected to a surface treatment such as a corona discharge treatment, flame treatment, glow discharge treatment, surface roughening treatment and chemical treatment.

Furthermore, a layer of an anchor coat agent may be formed on the resin film substrate relating to the invention for raising the contacting ability of the substrate with the ceramic layer. As the anchor coat agent to be used for the anchor coat layer, polyester resin, isocyanate resin, urethane resin, acryl resin, ethylene vinyl alcohol resin, vinyl-modified resin, epoxy resin, modified styrene resin, modified silicone resin and alkyltitanate are used singly or in combination of two or more kind of them. Know additives may be added to the anchor coat agent. The anchor coating can be performed by coating the anchor coat agent on the substrate by known method such as roller coat, gravure coat, knife coat, dip coat and spray coat on the substrate and removing the solvent and thinner by drying. The coating amount of the anchor coat agent is preferably about 0.1 to 5 g/m² in the dried state.

The long length resin film substrate in a rolled state is convenience. The thickness of the substrate cannot be sweepingly limited since the thickness is varied according to the use of the gas barrier film. When the gas barrier film is used as a packing material, the thickness is preferably from 3 to 400 µm, particularly from 6 to 30 µm, from the viewpoint of the suitability for packing though there is not any limitation.

The thickness of the resin substrate in the film state is preferably from 10 to 1,000 µm, more preferably from 50 to 500 µm, and further preferably from 80 to 200 µm.

### <<Atmosphere pressure plasma CVD method>>

The atmospheric pressure CVD method suitably usable for forming the ceramic layer in the production method of gas barrier film of the invention is described in detail below.

In the CVD (chemical vapor phase growth) method, an organic metal compound is vaporized or sublimated and deposited onto the surface of a substrate at high temperature and then thermally decomposed to form a thermally stable thin layer of inorganic substance. In such the usual CVD method (also called as thermal CVD method), is difficultly applied for layer forming on a plastic substrate because a substrate temperature of not less than 500 °C is usually required. Besides, in the plasma CVD method, an electric field is applied to the space near the substrate to generate a space (plasma space) in which gas in plasma state is in existence and the evaporated or sublimated organic metal compound is introduced into the plasma space and decomposed and then glown onto the substrate surface to form a thin layer of the inorganic substance. In the plasma space, the gas is ionized into ions and electrons in a high rate of several percent and the temperature of the electrons is very high even though the temperature of the gas is held at low. Therefore, the organic metal compound as the raw material of the inorganic layer can be decomposed at low temperature by contacting with the high temperature electrons or gas in excited state such as ions or radicals even at low temperature. Consequently, the temperature of the substrate can be lowered and the layer can be sufficiently formed on the resin film by this method.

However, in the plasma CVD method, the layer formation is usually carried out in a space in which the pressure is reduced by approximately 0.101 kPa to 10.1 kPa because it is necessary that the gas is ionized to make the plasma state by applying the electric field. Therefore, a problem of the production efficiency is caused in this method since a large apparatus and complicated operation are required for producing large area film.

In contrast, the pressure reduction is not necessary in the plasma CVD method carried out under near atmospheric pressure compared with the plasma CVD method under the vacuum, so that the high production efficiency can be obtained and the layer formation can be performed at high rate since the density of the plasma is high. Moreover, an extremely flat layer can be obtained since the mean free path of the gas is very shorter under a high pressure condition such as the atmospheric pressure compared with the condition of usual CVD method. Such the flat layer is superior in the optical properties and gas barrier ability. Accordingly, The application of the atmospheric pressure plasma CVD method is preferable compared with that of the plasma CVD method under vacuum.

The density of the ceramic layer formed on the resin film by this method is high and the thin layer having stable properties can be obtained. It is the special feature of this method that the ceramic layer which has a compressive remaining stress of from 0.01 to 20 MPa can be stably obtained.

The method for producing the gas barrier film of the invention is characterized in that the ceramic layer relating to the invention is formed by the thin layer forming method in which the gas containing the gases for forming the thin layer is supplied into the discharging space at the atmospheric or near atmospheric pressure and excited by applying high frequency electric field to the discharging space and the substrate is exposed to the resultant excited gas to form the thin layer on the substrate.

The producing method of the gas barrier film using the plasma CVD method under atmospheric or near atmospheric pressure is described below.

An example of plasma layer forming apparatus to be used in the production of the gas barrier film of the invention is described referring Figs. 2 to 5. Symbol F represents a long length film as an example of the substrate.

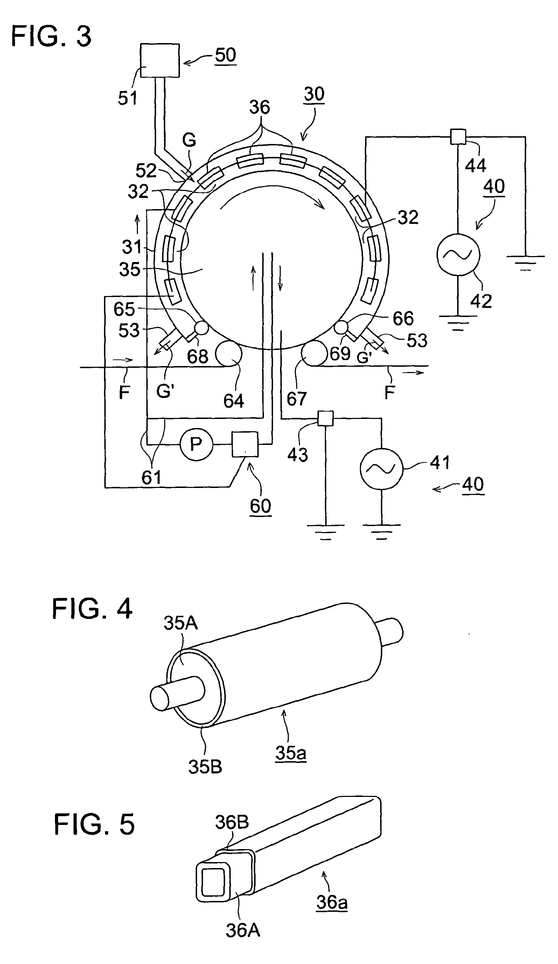

In the plasma discharge treating apparatus shown in Fig. 2 or 3, the ceramic layer can be obtained by supplying a mixture of suitably selected raw material gas containing the metal and the decomposition gas and mainly the discharging gas easily taking the state of plasma into the plasma discharge generation apparatus through a gas supplying means.

As above mentioned, nitrogen gas and/or an atom of Group 18 of the periodic table such as helium, neon, argon, krypton, xenon and radon are used as the discharging gas. Among them, nitrogen, helium and argon are preferably used and nitrogen is particularly preferable because of low cost.

Fig. 2 shows a jet type atmospheric pressure plasma discharge treatment apparatus which have a plasma discharge treatment apparatus, an electric field applying means having two power sources and a gas supplying means, and an electrode temperature controlling means which are not shown in Fig. 2 though they are described in Fig. 3.

The plasma discharge treatment apparatus 10 has facing electrodes constituted by a first electrode 11 and a second electrode 12, and a first high frequency electric field with frequency of ω₁, electric field strength of V₁ and electric current of I₁ is applied to the first electrode 11 from the first power source 21 and a second electric field with frequency of ω₂, electric field strength of V₂ and electric current of I₂ is applied to the second electrode 12 from the second power source 22. The first power source 21 can apply electric field strength stronger than that applied from the second power source 22 (V₁ > V₂) and the first power source 21 can apply frequency ω₁ lower than that ω₂ supplied from the second power source 22.

A first filter 23 is placed between the first electrode 11 and the first power source 21 so that the electric current from the first power source 21 to the first electrode 11 is easily passed and the electric current from the second power source 22 is grounded so that the current from the second power source 22 to the first power source 21 is difficultly passed.

A second filter 24 is placed between the second electrode 12 and the second power source 22 so that the electric current from the second power source 22 to the second electrode is easily passed and the electric current from the first power source 21 is grounded so that the electric current from the first power source 21 to the second power source is difficultly passed.

Gas G is introduced from a gas supplying means as shown in Fig. 3 into the space between the facing electrodes (discharging space) 13, the first electrode 11 and the second electrode 12, and discharging is caused by applying high frequency electric field from the first and second electrodes to make the gas G into the plasma state. Thus formed gas in the plasma state is blown as a jet stream toward the bottom side (lower side in the drawing) of the facing electrodes so that the treatment space constituted by the lower face of the facing electrodes and the substrate material F is filled by the gas G° in the plasma state. Thus a thin layer is formed near a treatment place 14 on the substrate material F conveyed from an unwinder while unwinding a rolled bulk or a preliminary process. While the layer formation, the electrodes are heated or cooled by a medium supplied from an electrode temperature controlling means such as that shown in Fig. 3 through piping. It is preferable that the temperature of the substrate material is suitably controlled because the preferable property and composition of the obtained thin layer are varied sometimes depending on the temperature of the substrate material on the occasion of plasma discharging treatment. As the medium of the temperature control, an electric insulation material such as distillated water and oil is preferably used. It is desirable that the interior temperature of the electrode is uniformly controlled so that any ununiformity of the temperature in the longitudinal and lateral directions is not caused on the occasion of the plasma discharge treatment.

Discharging in the gas in the same plasma state can be simultaneously performed by seriously arranging plural jet type atmospheric pressure plasma discharge treatment apparatuses. Consequently, the treatment can be rapidly performed by plural times of the treatment. Moreover, a laminated layers composed of layers different from each other can be formed by jetting different plasma state gases from each of the apparatuses, respectively.

Fig. 3 is a schematic drawing showing an example of atmospheric pressure plasma discharging apparatus in which the substrate material is treated between the facing electrodes effectively usable in the invention.

The atmospheric pressure plasma discharge treatment apparatus has at least a plasma discharge treatment apparatus 30, an electric field applying means 40 having two electric power sources, a gas supplying means 50 and an electrode temperature controlling means 60.

In Fig. 3, the thin layer is formed by plasma discharge treating the substrate material F between the facing electrodes (discharging space) 32 constituted by a rotating roller electrode (first electrode) 35 and a square columnar electrode group 36.

To the discharging space (space between the facing electrodes) 32 between the rotating roller electrode (the first electrode) 35 and the square columnar electrode group (the second electrode) 36, a first electric field of a frequency of ω₁, electric field strength V₁ and electric current I₁ is applied from a first power source 41 through the rotating roller electrode (the first electrode) 35 and a second electric field of a frequency of ω₂, electric field strength V₂ and electric current I₂ is applied from a second power source 42 through the square columnar electrode group (the second electrode) 36.

A first filter 43 is placed between the rotating roller electrode (the first electrode) 35 and the first power source 41 so that the electric current from the first power source 41 to the first electrode is easily passed and the electric current from the second power source 42 is grounded so that the current from the second power source 42 to the first power source is difficultly passed. A second filter 44 is placed between the square columnar electrode group (the second electrode) 36 and the second power source 42 so that the electric current from the second power source 42 to the second electrode is easily passed and the electric current from the first power source 41 is grounded so that the electric current from the first power source 41 to the second power source is difficultly passed.

In the invention, it is arrowed that the rotating roller electrode 35 and the square columnar electrode group 36 are each used as the second electrode and the first electrode, respectively. In both of the case, the first electrode is connected to the first power source and the second electrode is connected to the second power source. The strength of the high frequency electric field applied to the first electrode is preferably higher than that applied to the second electrode (V₁ > V₂). The frequency can be ω₁ < ω₂.

The electric current is preferably I₁ < I₂. The electric current I₁ of the first high frequency electric field is preferably from 0.3 mA/cm² to 20 mA/cm² and more preferably from 1.0 mA/cm² to 20 mA/cm². The electric current I₂ of the second electric field is preferably from 10 mA/cm² to 100 mA/cm² and more preferably from 20 mA/cm² to 100 mA/cm².

The gas G formed from a gas forming device 51 of the gas supplying means 50 is introduced into the plasma discharge treatment vessel 31 through a gas supplying opening 52 while controlling the flowing amount.

The substrate material F is conveyed while unwinding from the bulk roll or from the preliminary process and guided by a guide roller 64 to be introduced to nipping rollers 65 for insulating air accompanying with the substrate. And then the substrate material F is transferred between the rotating roller electrode 35 and the square columnar electrode group 36 while contacting around the rotating roller electrode, and electric field is applied from both of the rotating roller electrode (the first electrode) 35 and the square columnar electrode group (the second electrode) 36 to generate discharge plasma between the counter electrodes (discharge space) 32.

The thin layer is formed by the gas in the plasma state on the substrate material F which is conveyed while contacting rounding with the rotating roller electrode 35. The substrate material F is wound up by a winder not shown in the drawing or transferred to a next process through a nipping roller 66 and a guide roller 67.

The exhaust gas G' is exhausted after the discharging treatment through a exhausting opening 53.

A medium controlled in the temperature by an electrode temperature controlling means 60 is sent to the rotating roller electrode (the first electrode) 35 and the square columnar electrode 36 (the second electrode) by a liquid sending pump P through a piping 61 for heating or cooling the electrodes from the interior thereof. 68 and 69 are each a partition plate for parting the plasma discharge treating vessel 31 from outside during the thin layer formation.

Fig. 4 is perspective view showing an example of the structure of the electroconductive metal mother member and the dielectric material covering thereon of the rotating roller electrode.

In Fig. 4, the roller electrode 35a is composed of the electroconductive metal mother member 35A and the dielectric material 35B covering the mother member. The electrode 35a has a structure for circulating a temperature controlling medium such as water or silicon oil for controlling the surface temperature of the electrode during the plasma discharging treatment.

Fig. 5 is perspective view showing an example of the structure of the electroconductive metal mother member and the dielectric material covering thereon of the square columnar electrode.

In Fig. 5, the square columnar electrode 36a is composed of an electroconductive metal mother member 36A and a dielectric member 36B the same as that in Fig. 4 covering the mother member. The electrode has a metallic pipe-wise structure so that the temperature can be controlled during the discharging by utilizing the piping structure as a jacket.

Several square columnar electrodes are arranged along the circumference larger than that of the roller electrode and the discharging area of the square columnar electrodes is expressed by the sum of the area of the electrodes facing to the roller electrode 35.

The square columnar electrode 36a may be a cylindrical electrode, but the square columnar electrode is preferable in the invention because the square columnar electrode displays an effect of increasing the discharging range (discharging area) compared with the cylindrical electrode.

The roller electrode 35a and the square columnar electrode 36a shown in Figs. 4 and 5 are each prepared by sputtering ceramic as the dielectric materials 35B and 36B on the electroconductive metal mother members 35A and 36A, respectively, and sealing by an inorganic compound as the sealing material. The thickness of the dielectric ceramic layer may be about 1 mm. As the ceramic to be used for the sputtering, alumina and silicon nitride are preferable and alumina is particularly preferred since the processing can be easily performed. The dielectric material layer may be a lined layer formed by lining the inorganic material.

As the material of the electroconductive metallic mother member, a metal such as metallic titanium, titanium alloy, silver platinum, stainless steel and iron, a composite material of iron and ceramics and a composite material of aluminum and ceramics are cited, and metallic titanium and a titanium alloy are particularly preferable by the later-mentioned reason.

The distance between the first electrode and the second electrode is the shortest distance from the surface of the dielectric material to the surface of the metallic mother member of the other electrode when the dielectric material layer is provided on one of the electrodes and is the shortest distance between the dielectric material surfaces when the dielectric material layer is provided on each of the electrodes. The distance between the electrodes is decided considering the thickness of the dielectric material layer provided on the electroconductive metallic mother member, the strength of the applied electric field and the purpose of the application of plasma, and a distance of from 0.1 to 20 mm is preferable and that from 0.2 to 2 mm is particularly preferable in any case from the view point of uniform discharge.

Detail of the electroconductive metal mother member and the dielectric material are described later.

As the plasma discharge treatment vessel, a vessel of glass such as Pilex© glass is preferable but a vessel of metal can be used when the vessel can be insulated from the electrodes. For example, one prepared by affixing polyimide resin on a stainless steel frame or a metallic frame insulated by sputtered ceramics may be used. In Fig. 2, both of the diodes arranged in parallel are preferably covered by the above material on both sides (until near the surface of the substrate).

As the first power source (high frequency power source) to be installed in the atmospheric discharge treatment apparatus, the followings available on the market are usable.

| Symbol of power source | Manufacturer | Frequency | Product name |
|---|---|---|---|
| A1 | Shinko Elec. Co., Ltd. | 3 kHz | SPG3-4500 |
| A2 | Shinko Elec. Co., Ltd. | 5 kHz | SPG5-4500 |
| A3 | Kasuga Elec. Co., Ltd. | 15 kHz | AGI-023 |
| A4 | Shinko Elec. Co., Ltd. | 50 kHz | SPG50-4500 |
| A5 | Haiden Laboratory | 100 kHz* | PHF-6k |
| A6 | Pearl Kogyo Co., Ltd. | 200 kHz | CF-2000-200K |
| A7 | Pearl Kogyo Co., Ltd. | 400 kHz | CF-2000-400k |

As the second power source (high frequency power source) the followings available on the market are usable.

| Symbol of power source | Manufacturer | Frequency | Product name |
|---|---|---|---|
| B1 | Pearl Kogyo Co., Ltd. | 800 kHz | CF-2000-800K |
| B2 | Pearl Kogyo Co., Ltd. | 2 MHz | CF-2000-2M |
| B3 | Pearl Kogyo Co., Ltd. | 13.56 MHz | CF-2000-13M |
| B4 | Pearl Kogyo Co., Ltd. | 27 MHz | CF-2000-27M |
| B5 | Pearl Kogyo Co., Ltd. | 150 MHz | CF-2000-150M |

Among the above power sources, one with asterisk is an impulse high frequency power source (100 kHz at continuous mode) manufactured by Haiden Laboratory. The others are each a high frequency power source capable of applying continuous sign waves only.

In the invention, the electrode which can hold uniform and stable discharging state by applying the foregoing electric field is preferably used in the atmospheric plasma discharge treatment apparatus.

In the invention, the electric power applied between the facing electrodes supplies an electric power (output density) of not less than 1 W/cm² and excites the discharging gas to generate plasma and gives energy to the thin layer forming gas to form the thin layer. The upper limit of the electric power to be supplied to the second electrode is preferably 50 W/cm², and more preferably 20 W/cm². The lower limit is preferably 1.2 W/cm². The discharging area (cm²) is an area in which discharging is caused on the electrode.

An electric power (output density) of not less than 1 W/cm² is also supplied to the first electrode (the first high frequency electric field), by that the output density of the second electrode can be increased while keeping the uniformity of the high frequency electric field. BY such the operation, plasma having higher uniformity and density can be generated and further raising in the layer forming rate and raising in the quality of the layer can be compatibly attained. The electric power is preferably not less than 5 W/cm². The upper limit of the electric power to be supplied to the first electrode is preferably 50 W/cm².

The wave shape of the high frequency electric field is not specifically limited. There are a mode of oscillating continuous sign waves so called as a continuous mode and a mode oscillating intermittent waves generated by intermittently carrying out ON/OFF so called as a pulse mode. It is preferable that the wave to be supplied to the second electrode (the second high frequency electric field) is at least the continuous sign waves because the layer higher in the density and quality can be obtained, though both of the wave modes may be applied.

The electrode to be used for the thin layer forming method by the atmospheric plasma should be endurable to severe conditions as to the structure and the properties. As such the electrode, one composed of the metal mother member covered with the dielectric material is preferred.

As the dielectric material-covered electrode to be used in the invention, one in which the properties of the metal mother member and the dielectric material are coordinative is preferable. One of such the properties, a combination of the metal mother member and the dielectric material in which the difference between the liner thermal expansion coefficients of them is not more than 1 x 10⁻⁵/°C is cited. The difference is preferably not more than 8 x 10⁻⁶/°C, more preferably not more than 5 x 10⁻⁶/°C, and further preferably not more than 2 x 10⁻⁶/°C.

The followings are cited as the combination of the metal mother member and the dielectric material having the difference of the liner thermal expansion coefficient within the above range.
1: The metal mother member is pure titanium or a titanium alloy and the dielectric material is a sputtered layer of ceramic.
2: The metal mother member is pure titanium or a titanium alloy and the dielectric material is one formed by glass lining.
3: The metal mother member is stainless steel and the dielectric material is a sputtered layer of ceramic.
4: The metal mother member is stainless steel and the dielectric material is one formed by glass lining.
5: The metal mother member is a composite material of ceramic and iron and the dielectric material is a sputtered layer of ceramic.
6. The metal mother member is a composite material of ceramic and iron and the dielectric material is one formed by glass lining.
7: The metal mother member is a composite material of ceramic and aluminum and the dielectric material is a sputtered layer of ceramic.
8. The metal mother member is a composite material of ceramic and aluminum and the dielectric material is one formed by glass lining.

The combinations of the above 1, 2 and 5 to 8 are preferable and 1 is particularly preferred from the viewpoint of the difference of the liner thermal expansion coefficient.

In the invention, titanium and a titanium alloy are particularly useful for the metal mother member from the above property. The electrode can endure the use for long time under sever conditions without cracking, peeling and falling by the use of titanium or titanium alloy for the metal mother member and the above dielectric material.

As the atmospheric pressure plasma discharge treating apparatus, those described in Tokkai 2004-68143 and 2003-49272, and WO 02/48428 are usable other than the above-described.

The gas barrier film of the invention is described below.

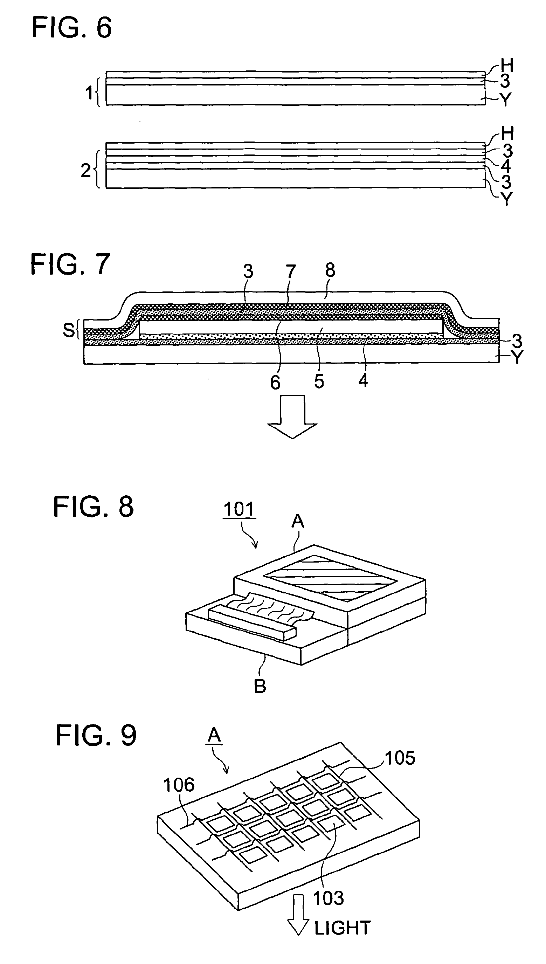

Fig. 6 is a schematic drawing displaying the layer structure of the transparent gas barrier film of the invention.

The gas barrier film 1 has a resin film substrate Y such as poly(ethylene terephthalate), a ceramic layer 3 and a smoothing layer (coated layer) H formed by coating a coating liquid containing a polymerizable inorganic compound provided on the substrate. The gas barrier film of the invention may have two or more laminated ceramic layers. The gas barrier film 2 may have the resin film substrate Y, at lest two of ceramic layers 3, a stress relaxation layer 4 containing a polymer lower in the elastic modulus than that of the ceramic layer and positioned between the two ceramic layers and a smoothing layer H containing an inorganic polymerizable compound and provided on the outer ceramic layer. It is preferable that the ceramic layer of the invention is separated into plural layers by arranging the stress relaxation layer when the ceramic layer is laminated because the ceramic layer of the invention has high dense structure and hardness. The stress relaxation layer has effects of relaxing the stress generated in the ceramic layer and preventing formation of cracks and defects in the inorganic ceramic layer.

The polymer to be used here is described below.

The polymer layer is a thin layer mainly composed of an inorganic polymer, an organic polymer or an organic-inorganic hybrid polymer and the thickness thereof is about 5 to 500 nm. The layer is relatively lower in the hardness than that of the gas barrier layer and the average carbon content of the layer is not less than 5%. Such the layer is also referred to as the stress relaxation layer.

The inorganic polymer applicable in the invention is a layer having an inorganic skeleton as the principal structure and containing an organic component and includes ones containing an organic metal compound.

As the inorganic polymer to be used in the invention, a silicon compound such as silicone and polysilazane, a titanium compound, an aluminum compound, a boron compound, a phosphor compound and a tin compound are usable for example, though there is no specific limitation.

Although the silicon compound usable in the invention is not specifically limited, preferable examples include tetramethylsilane, trimethylmethoxysilane, dimethyldimethoxsilane, methyltrimethoxysilane, trimethylmethoxysilane, dimethyldiethoxysilane, methyltriethoxysilane, tetramethoxysilane, tetramethoxysilane, hexamethyldisiloxane, hexamethyldisilazane, 1,1-dimethyl-1-silacyclobutane, trimethylvinylsilane, methoxydimethylvinylsilane, trimethoxyvinylsilane, ethyltrimethoxysilane, dimethyldivinylsilane, dimethyletoxyethynylsilane, diacetoxydimethylsilane, dimethoxymethyl-3,3,3-trifluoropropylsilane, 3,3,3-trifluoropropyltrimethoxysilane, aryltrimethoxsilane, ethoxydimethyldivinylsilane, arylaminotrimethoxysilane, N-methyl-N-trimethylsilylacetamide, 3-aminopropyltrimethoxysilane, methyltrivinylsilane, diacetoxymethylvinylsilane, methyltriacetoxysilane, aryloxidimethylvinylsilane, diethylvinylsilane, butyltrimethoxsilane, 3-aminopropyldimethylethoxysilane, tetravinylsilane, triacetoxyvinylsilane, tetracetoxysilane, 3-trifluoroacetoxypropyltrimethoxysilane, diaryldimethoxysilane, butyldimethoxyvinylsilane, trimethyl-3-vinylthiopropylsilane, phenyltrimethylsilane, dimethoxmethylphenylsilane, phenyltrimethoxysilane, 3-acryloxypropyldimethoxymethylsilane, 3-acryloxypropyltrimethoxysilane, dimethylisopentyloxyvinylsilane, 2-aryloxyethylthiomethoxytrimethylsilane, 3-glycidoxypropyltrimethoxysilane, 3-arylaminopropyltrimethoxysilane, hexyltrimethoxysilane, heptadecafluorodecyltrimethoxysilane, dimethylethoxyphenylsilane, benzoyloxytrimethylsilane, 3-methacryloxypropyldimethoymethylsilane, 3-methcryloxypropyltrimethoxysilane, 3-isocyanatopropyltriethoxysilane, dimethylethox-3-glycidoxypropylsilane, dibutoxydimethylsilane, 3-butylaminopropyltrimethylsilane, 3-dimethylaminopropyldiethoxysilane, 2-(2-aminoethyltioethyl)-triethoxysilane, bis(butylamino)dimethylsilane, divinylmethylphenylsilane, diacetoxymethylphenylsilane, dimethyl-p-tolylvinylsilane, p-styryltrimethoxysilane, diethylmethylphenylsilane, benzyldimethylethoxysilane, diethoxymethylphenylsilane, decylmethyldimethoxysilane, diethoxy-3-glycidoxypropylmethylsilane, octyloxytrimethylsilane, phenyltrivinylsilane, phenyltrivinylsilane, tetraryloxysilane, dodecyltrimethylsilane, diarylmethylphenylsilane, diphenylmethylvinylsilane, diphenylethoxymethylsilane, diacetoxydiphenylsilane, dibenzyldimethylsilane, diaryldiphenylsilane, octadecyltrimethylsilane, methyloctadecyldimethylsilane, docosylmethyldimetylsilane, 1,3-divinyl-1,1,3,3-tetramethyldisiloxane, 1,3-divinyl-1,1,3,3-tetramethylsilazane, 1,4-bis(dimethylvinylsilyl)-benzene, 1,3-bis(3-acetoxypropyl)tetramethyldisiloxane, 1,3,5-trimethyl-1,3,5-trivinylcyclotrisiloxane, 1,3,5-tris(3,3,3-trifluoropropyl)-1,3,5-trimethylcyclotrisiloxane, octamethylcyclotetrasiloxane, 1,3,5,7-tetraethoxy-1,3,5,7-tetramethylcyclotetrasiloxane and decamethylcyclopentanesiloxane.

Known polymerizable organic compounds can be used as the organic polymer. Among them, a polymerizable ethylenic unsaturated compound having an ethylenic unsaturated bond in the molecule thereof is preferable. Furthermore, multi-functional monomers and multi-functional oligomers each having plural addition polymerizable ethylenic double bonds are usually used in a resin curable by light, heat or UV are usable.

Although there is no specific limitation on such the polymerizable ethylenic double bond-containing compounds, preferable examples include mono-functional acrylates such as 2-ethylhexyl acrylate, hydroxypropyl acrylate, glycerol acrylate, tetrahydrofuryl acrylate, phenoxyethyl acrylate, nonylphenoxyethyl acrylate, tetrahydrofuryloxyethyl acrylate, tetrahydrofuryloxyhexanolide acrylate, acrylate of ε-caprolactone adduct of 1,3-dioxane alcohol, and methacrylates, itaconates, crotonates and maleates formed by replacing acrylic acid in the above esters by methacrylic acid, itaconic acid, crotonic acid; di-functional acrylates; di-functional acrylates such as ethyleneglycol diacrylate, triethyleneglycol diacrylate, pentaerythrytol diacrylate, hydroquinone diacrylate, resorcin diacrylate, hexandiol diacrylate, neopentylglycol diacrylate, tripropyleneglycol diacrylate, diacrylate of neopentylglycol hydroxylpivalate, diacrylate of neopentyglycol adipate, diacrylate of ε-caprolactone adduct of neopentylglycol hydroxypivalate, 2-(2-hydroxy-1,1-dimethylethyl)-5-hydroxymethyl-5-ethyl-1,3-dioxane diacrylate, tricyclodecanedimethylol acrylate, ε-caprolactone adduct of tricyclodecanedimethylol acrylate and diacrylate of glycidyl ether of 1,6-hexanediol, and methacrylates, itaconates, crotonates and maleates formed by replacing acrylic acid in the above esters by methacrylic acid, itaconic acid, crotonic acid; and poly-functional acrylate such as trimethylolpropane triacrylate, ditrimethylolpropane tetracrylate, trimethylolethane triacrylate, pentaerythrytol triacrylate, pentaerythrytol tetracrylate, dipentaerythrytol tetracrylate, dipentaerythrytol pentacrylate, dipentaerythrytol hexacrylate, ε-caprolactone adduct of dipentaerythrytol hexacrylate, pyrogallol triacrylate, propionic acid·dipentaerythrytol triacrylate, propionic acid· dipentaerythrytol tetracrylate and hydroxypivalylaldehyde-modified dimethylolpropane triacryloate, and methacrylates, itaconates, crotonates and maleates formed by replacing acrylic acid in the above esters by methacrylic acid, itaconic acid, crotonic acid.

Prepolymers also may be used the same as the above. The prepolymer may be used singly or in combination of two or more kinds thereof. The prepolymer may be used together with the above monomers or oligomers.

Examples of the prepolymer include polyester acrylates formed by introducing (meth)acrylic acid into a polyester obtained by a polybasic acid such as adipic acid, trimellitic acid, maleic acid, phthalic acid, terephthalic acid, himic acid, moronic acid, succinic acid, glutaric acid, itaconic acid, pyromellitic acid, fumaric acid, glutaric acid, pimelic acid, sebacic acid, dodecanic acid and tetrahydrophthalic acid, and a polyol such as ethylene glycol, propylene glycol, diethylene glycol, propyleneoxide, 1,4-butanediol, triethylene glycol, tetraethylene glycol, poly(ethylene glycol, glycerol, trimethylolpropane, penthaerythrytol, sorbitol, 1,6-hexanediol and 1,2,6-hexanetriol; epoxyacrylates formed by introducing (meth)acrylic acid into an epoxy resin such as bisphenol A, epichlorohydrine·(meth)acrylic acid and phenolnovolac·epichlorohydrine·(meth)acrylic acid; urethane acrylates formed by formed by introducing (meth)acrylic acid into a urethane resin such as ethylene glycol·adipic acid·tolylenediiocyanate-2-hydroxyethyl acrylate, polyethylene glycol·tolylenediisocyanate·2-hydroxyethyl acrylate, hydroxyethylphthalyl methacrylate·xylenediisocyanate, 1,2-polybutadiene glycol·tolylenediisocyanate·2-hydroxyethyl acrylate and trimethylolpropane·propylene glycol·tolylenediisocyanate· 2-hydroxyethyl acrylate; silicone resin acrylates such as polysiloxane acrylate and polysiloxane·diisocyanate· 2-hydroxyethyl acrylate; alkyd-modified acrylates formed by introducing a (meth)acryloyl group into oil-modified alkyd resin; and psirane resin acrylate.

In the invention, the organic polymer applicable in the polymer layer can be easily formed by using a plasma polymerizable organic compound as the thin layer forming gas. As the plasma polymerizable organic compound, hydrocarbons, vinyl comounds, halogen-containing compounds and nitrogen-containing compound can be cited. The organic polymer layer is preferably provided at a position nearer the substrate than the ceramic layer.

As the hydrocarbon, ethane, ethylene, methane, acetylene, cyclohexane, benzene, xylene, phenylacetylene, naphthalene, propylene, camphor, menthol, toluene and isobutylene can be cited for example.

As the vinyl compound, acylic acid, methyl acrylate, ethyl acrylate, methylmethacrylate, allyl methacrylate, acrylamide, styrene, α-methylstyrene, vinylpyridine, vinyl acetate and vinyl methyl ether can be cited for example.

As the halogen-containing compound, tetrafluoromethane, tetrafluoroethylene, hexafluoropropylene and fluoroalkyl methacrylate can be cited for example.

As the nitrogen-containing compound, pyridine, allyamine, butylamine, acrylonitrile, acetonitrile, benzonitrile and aminobenzene can be cited for example.

In the invention, as the organic-inorganic hybrid polymer, an organic (inorganic) polymer layer in which inorganic (organic) material is dispersed and a layer having an inorganic skeleton and an organic skeleton as the principal structure. The organic-inorganic hybrid polymer applicable to the invention is not specifically limited and one composed of suitable combination as above-described is preferably usable.

The gas barrier film of the invention can be used as various sealing materials or films.

The gas barrier film of the invention can be also used for displaying apparatus such as the EL device. When the gas barrier film is used in the organic EL device, the device can be constituted by the use of the gas barrier layer as the substrate so that light can be taken out from the substrate side since the gas barrier film is transparent. Namely, a resin substrate for organic electroluminescent device can be constituted by providing a transparent electroconductive thin layer such as an ITO layer as a transparent electrode. On the transparent electroconductive ITO layer as the anode, an organic EL material layer containing a light emission layer and a cathode composed of metal layer are provided to form an organic EL device. The organic EL device layer can be sealed by covering the device by another sealing material which may be the same material as the gas barrier film, and pasting sealing material with the gas barrier film substrate at the around of the device. Thus influences of the exterior atmosphere gas such as moisture and oxygen can be sealed out.

The resin base material is obtained by forming the electroconductive transparent layer on the ceramic layer of thus formed gas barrier film. The transparent electroconductive layer is the layer to be the anode when the organic EL device is constituted.

The transparent electroconductive layer can be formed by a vacuum deposition method, sputtering method or also a sol-gel coating method using a metal alkoxide such as that of indium or tin and the ITO layer superior in the electroconductivity of the order of relative resistivity 10⁻⁴ Ω·cm can be obtained. The transparent electroconductive layer is preferably formed by the atmospheric pressure plasma CVD method using a metal alkoxide or alkyl metal of indium or tin.

The ITO layer superior in the electroconductivity of the order of 10⁻⁴ Ω·cm can be industrially obtained by using a DC magnetron sputtering apparatus; however, the layer is formed by depositing and growing the subjective material in gas phase onto the substrate in such the physical method (PVD method). Therefore, large and expensive equipment is necessary since a vacuum vessel is used and the efficiency of the raw material and production efficiency are low and the production of large size layer is difficult. Moreover, heating at a temperature of from 150 to 300 °C on the occasion of layer formation is necessary for obtaining the layer with low resistivity and formation of the transparent electroconductive layer having low resistivity is difficult. Therefore, the layer formation by the foregoing atmospheric pressure discharge apparatus is preferred.

The gas to be used for formation of the transparent electroconductive layer is basically mixed gas of inert gas and reactive gas for forming the transparent electroconductive layer capable of taking plasma state though the gas is varied depending on the kind of the transparent electroconductive layer. The inert gas is an element including in Group 18 of periodic table such as helium, neon, argon, krypton, xenon and radon, and nitrogen gas and argon, mentioned as above, and helium are particularly preferable. Plural kinds of the reactive gas can be used in the invention and at least one of them is one capable of being into plasma state in the discharging space and contains a component for forming the transparent electroconductive layer. An organic metal compound is preferably used as the reactive gas though the gas is not specifically limited. The kind of the organic metal compound is not limited and organic metal compounds having an oxygen atom in the molecule thereof, β-diketone metal complexes, metal alkoxides and alkyl metals are particularly preferred. Examples of the organic metal compound include indium hexafluoropentanedionate, indium methyl(trimethyl)-acetylacetate, indium acetylacetonate, indium isopropoxide, indium trifluoropentanedionate, indium tris(2,2,6,6-tetramethyl-3,5-heptanedionate), tin di-n-butyl-bis(2,4-pentanedionate), di-n-butyldiacetoxy tin, di-t-butyldiacetoxy tin, tetraisopropoxy tin, tetrabutoxy tin and zinc and zinc acetylacetonate.

Among them, indium acetylacetonate, indium tris(2,2,6,6-teramethyl-3,5-heptanedionate), zinc acetoacetonate and di-n-butyldiacetoxy tin are particularly preferable. These organic compounds are available on the market, for example, indium acetoacetonate can be easily obtained from Tokyo Chemical Industry Co., Ltd.

In the formation of the electroconductive layer, gas for doping for raising the electroconductivity can be used additionally to the organic metal compound containing at least one oxygen atom in the molecule thereof. As the gas for doping, aluminum isopropoxide, nickel acetylacetonate, manganese acetylacetonate, boron isopropoxide, n-butoxy antimony, tri-n-butyl antimony, tin di-n-butyl-bis(2,4-pentandionate), di-n-butyldiacetoxy thin, di-t-butyldiacetoxy tin, tetraisopropoxy tin, tetrabutoxy tin, tetrabutyl tin, zinc acetylacetonate, hexafluoroporpylene, octafluorocyclobutane and tetrafluoromethane can be cited.

The transparent electroconductive layer having high electroconductivity and showing high etching rate can be produced by using water as the reactive gas additionally to the reactive gas containing the transparent electroconductive layer constituting element. The amount of water to be mixed with the reactive gas is preferably within the range of from 0.0001% to 10% of the mixture of the reactive gas and the inert gas. It is more preferably between 0.001 to 1%.

As the reactive gas, oxidation gas such as oxygen, a reduction gas such as hydrogen, nitrogen monoxide, nitrogen dioxide, carbon monoxide and carbon dioxide may be suitably used other than the organic metal compound containing the element constituting the transparent electroconductive layer and water.

The amount ratio of the reactive gas to be used in a small amount for doping to the reactive to be used as the principal composition of the transparent electroconductive layer is varied according to the kind of the transparent electroconductive layer to be formed. For example, the amount of the reactive gas is controlled in the formation of ITO layer of indium doped with tin so that the atom number ratio of In:Sn is within the ratio of from 100:0.1 to 100:15, preferably from 100:0.5 to 100:10. The atom number ratio Sn:F in the obtained FTO layer can be determined by XPS measurement. In In₂O₃-ZnO type amorphous transparent electroconductive layer, the amount ratio of the reactive gas is controlled so that the atom number ratio is within the range of from 100:50 to 100:5. The atom number ratio of In:Zn can be determined by XPS measurement.

The reactive gas includes the reactive gas for making the principal composition of the transparent electroconductive layer and the reactive gas to be used in a small amount for doping. Moreover, silicon is introduced in the invention additionally to the principal metal element for constituting the transparent electroconductive layer and the metal element for doping. Silicon can be introduced in a form of reacting gas for controlling the resistivity of the transparent electroconductive layer on the occasion of the layer forming though the method for introducing silicon is not specifically limited. As the reactive gas for controlling the resistivity of the transparent electroconductive layer, an organic metal compound particularly β-diketone metal complexes, metal alkoxides and alkyl metals are preferably usable. The followings are cited in concrete. As the silicon compound, tetramethoxysilane, tetraethoxysilane, tetra-iso-propoxysilane, tetra-n-propoxysilane, tetra-n-butoxysilane, tetra-sec-butoxysilane, tetra-tert-butoxysilane, methyltrimethoxysilane, methyltriethoxysilane, methyltripropoxysilane, methyltributoxysilane, dimethyldimethoxysilane, dimethyldiethoxysilane, dimethylethoxysilane, dimethylmethoxysilane, dimethylpropoxysilane, dimethylbutoxysilane, methyldimethoxysilane, methylsiethoxysilane and hexyltrimethoxysilane are cited. Among them, tetraethoxysilane is preferable from the viewpoint of stability and the vapor pressure.

The thickness of the transparent electroconductive layer is preferably from 0.1 nm to 1,000 nm.

In the case of the transparent electroconductive layer, the properties of the layer can be controlled by heating after formation under near the atmospheric pressure. By the heat treatment, the amount of hydrogen in the layer can be varied. Temperature for the heat treatment is preferably within the range of from 50 to 300 °C, more preferably from 100 to 200 °C. The atmosphere of the heating is not specifically limited. The atmosphere is suitably selected from an air atmosphere, a reductive atmosphere containing reductive gas such as hydrogen, an oxidizing atmosphere containing oxidizing gas such as oxygen, a vacuum atmosphere and an inert gas atmosphere. When the reductive or oxidizing atmosphere is applied, it is preferable that the reactive gas or oxidizing gas is diluted by an inert gas such as rare gas and nitrogen gas. In such the case, the concentration of the reductive gas or the oxidizing gas is preferably from 0.01 to 5% and more preferably from 0.1 to 3%.

The transparent electroconductive layer formed by the forming method of the invention some times contains slight amount of carbon since the organic metal compound is used as the reactive gas. In such the case, the content of the carbon is preferably within the range of from 0 to 5.0, particularly from 0.01 to 3, in the atom number concentration.

In the invention, the ceramic layer or the transparent electroconductive layer is formed under near atmospheric pressure and the temperature at the layer formation is not specifically limited. The temperature is preferably not more than 300 °C when a glass substrate is used and not more than 200 °C when the later-mentioned polymer resin substrate is used.

The organic electroluminescent device using the gas barrier film of the invention or the resin base formed by providing the transparent electroconductive layer on the gas barrier film is described below.

### (Sealing film and production method thereof)

It is one of the characteristics of the organic electroluminescent device of the invention that the gas barrier film of the invention having the ceramic layer and the coated layer is used as the substrate material. The transparent electroconductive layer as the anode is formed on the ceramic layer and the coated layer of the gas barrier film of the invention and the organic EL material layer constituting the organic EL device and a metal layer to be an cathode are formed on the anode and then another gas barrier film is overlapped and pasted as the sealing film to seal the device.

The gas barrier film of the invention which has the ceramic layer with dense structure and the coated layer containing the polymerizable inorganic compound can be used as the other sealing material (sealing film). Moreover, known gas barrier film usually used for packing material such as plastic film on which silicon oxide or aluminum oxide is vapor deposited or gas barrier film constituted by a substrate on which dens ceramic layers and flexible shock absorbing layers are alternatively laminated and a coated layer is provided at the outermost portion as a smoothing layer can be used as the sealing film. Resin (polymer layer) laminated metal foil which is low in the cost and moisture permeability can not be used for the gas barrier film on the light taking out side but such the laminated foil is preferable as the sealing film when the transparency is not required or taking out of light is not intended.

In the invention, the metal foil is foil or film of metal formed by rolling, which is different from a metal thin layer formed by sputtering or vapor deposition and an electroconductive layer formed by a fluidable electrode material such as electroconductive past.

There is no limitation as to the kind of metal of the metal foil, and foil of copper (Cu), aluminum (Al), gold (Au), brass, nickel (Ni), titanium (Ti), copper alloy, stainless steel, tin (Sn) and high nickel alloy are cited. Among these metal foils, aluminum foil is cited as particularly preferable metal foil.

The thickness of the metal foil is preferably from 6 to 50 µm. When the thickness is not less than 6 µm, occurrence of pin hole at the using time can be prevented regardless to the kind of the metal and necessary barrier ability (moisture permeability and oxygen permeability) can be held. When the thickness is not more than 50 µm, the highest economics performance can he held according to the material used in the foil and the thickness of the organic EL device can be inhibited so as not to be excessively thick so as to sufficiently realize the merits of the film.

As the resin film of the resin film (polymer layer) laminated metal foil, various materials described in "New Development of Functional Packing Material", Toray Research Center, can be applied; for example, polyethylene type resin, polypropylene type resin, poly(ethylene terephthalate) type resin, polyamide type resin, ethylene-vinyl alcohol copolymer type resin, ethylene-vinyl acetate copolymer type resin, acrylonitrile-butadiene type resin, cellophane type resin, vinylon type resin and vinylidene chloride type resin are cited. Polypropylene type resin and nylon type resin may be stretched or coated with vinylidene chloride resin. Low density and high density polyethylene type resin can be used.

Among the above resins, nylon (Ny), nylon coated with vinylidene chloride (PVDC), non-stretched polypropylene (CPP), stretched polypropylene (OPP), polypropylene coated with PVDC (KOP), poly(ethylene terephthalate) (PET), cellophane coated with PVDC (KPT), polyethylene-vinyl alcohol copolymer (Epal), low density polyethylene (LDPE), high density polyethylene (HDPE) and linear low density polyethylene (LLDPE) are preferably used. The thermoplastic film may be a multilayered film prepared by co-extruding together with another kind film or a multilayered film prepared by laminating films each different in the stretching angle from each other according to necessity. It is possible of course that the density and the molecular weight distribution of the film are suitably combined for obtaining necessary properties for the packing material.

The thickness of the polymer layer is preferably from 3 to 400 µm, more preferably from 10 to 200 µm, and further preferably from 10 to 50 µm though the thickness cannot be sweepingly decided.

A method using usually using laminating machine can be applied for coating (laminating) polymer layer onto one side of the metal foil. An adhesive such as polyurethane type, polyester type, epoxy type and acryl type adhesive can be used as the adhesive. A curing agent may be used in combination according to necessity. A dry lamination method, hot-melt lamination method and an extrusion lamination method can be applied and the dry lamination method is preferable.

The film composed of the metal foil coated with the polymer layer on one side is sold on the market for packing material. For example, a dry laminated film having a constitution of Adhesion layer/Aluminum film of 9µm/Poly(ethylene terephthalate) (PET) of 38 µm which contains an adhesion layer of two component type urethane type adhesive with a thickness of 1.5 µm, is available and the cathode side of the organic EL element can be sealed by this film.

A film composed of the metal foil coated with a polymer layer on one side thereof and a ceramic layer is formed on the another side of the metal foil is preferably used as the sealing film. The ceramic layer is preferably a ceramic layer relating to the invention and the thickness thereof is within the range of from 1 to 2,000 nm and the layer is formed by the atmospheric pressured plasma method the same as the above.

As later-mentioned, the two films are preferably sealed by a method in which the impulse fusible resin layers are laminated and fused by impulse sealer to seal the films. In such the case, the handling suitability of the film on the occasion of the sealing operation of the gas barrier films is lowered and thermal fusion by the impulse sealer becomes difficult when the thickness of the film exceeds 300 µm, therefore the thickness of the film is desirably not more than 300 µm.

### (Sealing of organic EL device)

In the invention, the organic electroluminescent device can be sealed as follows; the transparent electroconductive layer is formed on the resin film (gas barrier film) having the ceramic layer and the coated layer of the invention, and the organic EL device layers are provided on the resultant substrate material for organic electroluminescent device and then the sealed by the above-described sealing film so as to cover the cathode surface under an environment purged by inert gas.

As the inert gas N₂, and a rare gas such as He and Ar are preferably used and a mixture of He and Ar is also preferable. The content of water vapor and oxygen in the gas is preferably not more than 1 ppm. The storage ability of the device is improved by sealing under environment purged by the inert gas.

When the organic EL device is sealed by the metal foil laminated with the resin film (polymer layer), it is preferable that the ceramic layer is formed on the metal foil surface, not the resin layer surface, and the ceramic surface is pasted to the cathode of the organic EL device. When the polymer surface of the sealing film is pasted with the cathode of the organic EL device, partial electric conduction and electric erosion accompanied with the partial conduction are caused so that dark spots are caused sometimes.

As the sealing method by pasting the sealing film with the cathode of the organic EL device, a method is applicable in which a thermally fusible film such as film of ethylene-vinyl acetate copolymer (EVA), polypropylene (PP) and polyethylene (PE) is laminated and fused by the impulse sealer for sealing.

The dry lamination method is superior in the operation suitability. In this method, a curable resin layer of about 1.0 to 2.5 µm is usually used. The amount of the adhesive is preferably controlled so that the dry thickness of the adhesive is 3 to 5 µm because tunnels, oozing out and reticulation are caused some times when the coating amount of the adhesive is excessively thick.

The hot-melt lamination is a method in which a hot-melt adhesive is melted and coated on the substrate to form an adhesive layer and the thickness of the adhesive can be widely set so as to be from 1 to 50 µm. EVA, EEA, polyethylene and butyl rubber are used as the base resin of usually used hot-melt adhesives and adhesing ability providing agent such as rosin, xylene resin, terpene type resin and styrene type resin and a plasticizer such as wax are added.

The extrusion lamination method is a method in which resin melted at high temperature is coated on the substrate through a die and the thickness of the resin layer can be set in widely range so as to be from 10 to 50 µm.

LDPE, EVA and PP are usually used for the extrusion lamination.

A schematic cross section of an organic EL which is prepared by forming the organic EL device layers on the gas barrier film of the invention and then the gas barrier film is attached with the resin laminated aluminum foil having a silicon oxide layer is shown.

In Fig. 7, on the gas barrier film having a ceramic layer 3 including the coated layer relating to the invention formed on the resin film substrate Y, an anode (ITO) 4, organic EL layers 5 and a cathode (aluminum for example) 6 are formed for constituting the organic EL device. The cathode is overlapped by a sealing film S and the organic EL device including the organic EL material layers is sealed by adhering at the circumference. In the sealing film S, the ceramic layer 3 including the coated layer relating to the invention is formed on the metal (aluminum) foil 7 and a resin layer 8 is laminated on the opposite side of the metal foil. The sealing film is pasted to the device so that the ceramic 3 side is touched to the cathode. The arrow shows the light taking light direction.

A moisture absorbing material may be arranged in the sealing structure of the sealed space and a layer for absorbing water vapor such as a moisture absorbing layer may be provided in such the sealing structure.

The organic EL material layers (constituting layers) constituting the organic EL device is described below.

In the invention, the device having a phosphorescent type light emission layer containing a phosphorescent dopant is preferable since such the device has high light emission efficiency. Detail of the organic EL layers is described later.

The constituting layer of the organic EL device relating to the invention is described in detail below. Preferable examples of the layer constitution of the organic EL device of the invention are shown below but the invention is not limited to them.
(1) Anode/Light emission layer/Electron transfer layer/Cathode
(2) Anode/Positive hole transfer layer/Light emission layer/Electron transfer layer/Cathode
(3) Anode/Positive hole transfer layer/Light emission layer/Positive hole blocking layer/Electron transfer layer/Cathode
(4) Anode/Positive hole transfer layer/Light emission layer/Positive hole blocking layer/Electron transfer layer/Cathode buffer layer/Cathode
(5) Anode/Anode buffer layer/Positive hole transfer layer/Light emission layer/Positive hole blocking layer/Electron transfer layer/Cathode buffer layer/Cathode

### (Anode)

An anode using a metal with high work function (not less than 4 eV), alloy, electroconductive compound and a mixture of them as the electrode material is preferably used. As the concrete examples of such the electrode material, a metal such as Au, and a transparent electroconductive material such as CuI, indium tin oxide (ITO), SnO₂ and ZnO are cited. Moreover, an amorphous material capable of forming the transparent electroconductive layer such as IDIXO (In₂O₃-ZnO) may be also usable. The anode is formed by forming a thin layer of such the electrode material by vapor deposition or sputtering and the desired pattern may be formed by a photolithographic method. In the case requiring not so high pattern accuracy (not less than 100 µm), the pattern may be formed by performing the vapor deposition or the sputtering through a mask having the desired shape of pattern. When the light is taken out through the anode, the transmittance is desirably not less than 10% and the sheet resistance of the anode is preferably not more than several hundreds ohms per square meter. The layer thickness is usually from 10 to 1,000 nm, preferably from 10 to 200 nm.

### (Cathode)

As the cathode, one composed of a metal with low work function (not more than 4 eV) so called as electron injection metal, an alloy, an electroconductive compound and a mixture of them are used. Concrete examples of such the electrode material include sodium, a sodium-potassium alloy, magnesium, lithium, a magnesium/copper mixture, a magnesium/silver mixture, a magnesium/aluminum mixture, a magnesium/indium mixture, an aluminum/aluminum oxide (Al₂O₃) mixture, indium, a lithium/aluminum mixture, a lithium/aluminum mixture and a rare-earth metal. Among them, a mixture of the electron injective metal and a second metal having high work function and stability such as the magnesium/silver mixture, magnesium/aluminum mixture, magnesium/indium mixture, aluminum/aluminum oxide (Al₂O₃) mixture, lithium/aluminum mixture and aluminum is suitable. The cathode can be prepared by forming a thin layer of such the material by vapor deposition or sputtering. The sheet resistance of the cathode is preferably not more than several hundreds ohms per square meter and the thickness is usually from 10 nm to 50 µm and preferably from 50 to 200 nm. It is advantageous that one of the anode and cathode of the organic EL device is transparent or translucent for permeation the emitted light.

A transparent or translucent cathode can be prepared by forming the electroconductive material described as to the anode after formation of the cathode layer of the foregoing metal having a thickness of from 1 to 20 nm. A device having transparent anode and transparent cathode can be obtained by using the above cathode.

An injection layer, blocking layer and electron transfer layers to be used as the constituting layer of the organic EL device of the invention are described below. (Injection layer: electron injection layer and positive hole injection layer)

The injection layer is provided according to necessity, which includes an electron injection layer and a positive hole injection layer, and may be arranged between the anode and the light emission layer or the positive hole transfer layer, and between the cathode and light emission layer or the electron transfer layer as above-mentioned.

The injection layer is a layer to be provided between the electrode and the organic layer for lowering the driving voltage and raising the luminance of emitting light. The injection layer is described in detail in " "Organic EL element and Its Forefront of Industrialization" Sec. 2, Chapter 2, "Electrode Material" pp. 123-166, Pub. By NTS, Nov. 30, 1998. The injection layer includes the positive hole injection layer (cathode buffer layer) and the electron injection layer (anode buffer layer).

The anode buffer layer (positive hole injection layer) is also described in detail in Tokkai Hei 9-45479, 9-260062 and 8-288069 and concrete examples thereof include a phthalocyanine buffer layer typified by copper phthalocyanine, an oxide buffer layer typified by vanadium oxide, an amorphous carbon buffer layer and a polymer buffer layer using an electro conductive polymer such as polycyanine (emraldin).

The cathode buffer layer (electron injection layer) is also described in detail in Tokkai Hei 6-325871, 9-17574 and 10-74586 and concrete examples include a metal buffer layer typified by strontium and aluminum, an alkali metal compound buffer layer typified by lithium fluoride, an alkali-earth metal compound buffer layer typified by magnesium fluoride and an oxide buffer layer typified by aluminum oxide. The above buffer layer (injection layer) is preferably an extreme thin layer and the thickness is preferably from 0.1 nm to 5 µm.

### (Blocking layer: Positive hole blocking layer and electron blocking layer)

As above-mentioned, the blocking layer is provided according to necessity additionally to the basic constitution layer of the organic compound thin layer. In concrete, the positive hole blocking layer (hole blocking layer) described in, for example, Tokkai Hei 11-204258 and 11-204359, and "Electrode Material" p 237 Pub. By NTS, Nov. 30, 1998 is cited.

The positive hole blocking layer has the function of electron transfer layer in wide means and is composed of a positive hole blocking material having the electron transfer function and considerably low positive hole transfer ability, by which the recombination probability of the electron and the positive hole can be raised by blocking the positive hole while transferring the electron. The later-mentioned constitution of the electron transfer layer can be applied as the positive hole blocking layer relating to the invention according to necessity.

Besides, the electron blocking layer has the function of positive hole transfer layer in wide means and is composed of a material having the positive hole transfer function and considerably low electron transfer ability, by which the recombination probability of the electron and the positive hole can be raised by blocking the electron while transferring the positive hole. The later-mentioned constitution of the positive hole transfer layer can be applied as the electron blocking layer according to necessity.

### (Light emission layer)

The light emission layer relating to the invention is a layer in which the electron and the positive hole each injected from the electron transfer layer and the positive hole transfer layer, respectively, are recombined to emit light. The portion of the light emission may be interior of the light emission layer or the interface of the light emission layer and the adjacent layer.

The following host compound and a dopant compound are preferably contained in the light emission layer of the organic EL device of the invention. The efficiency of light emission can be raised by such the constitution.

The light emission dopant can be roughly classified into a fluoresce dopant emitting fluorescence and a phosphoresce dopant emitting phosphorescence.

Typical examples of the former (fluoresce dopant) include coumalin type dyes, pyrane type dyes, cyanine type dyes, chroconium dyes, squalium type dyes, oxobenzanthrathene type dyes, fluorescein type dyes, rhodamine type dyes, pyrylium type dyes, perylene type dyes, stilbene type dyes, polythiophene type dyes, and rare-earth complex type fluorescent substances.

The typical examples of the later (phosphoresce dopant) are preferably complex compounds containing a metal of Groups 8, 9 and 10 of the periodic table and more preferably iridium compounds and osmium compounds, and the iridium compounds are most preferable. In concrete, they are the compounds described in the following patent publications.

WO 00/70655, Tokkai 2002-280178, 2001-181616, 2002-280179, 2001-181617, 2002-280180, 2001-247859, 2002-299060, 2001-313178, 2002-302671, 2001-345183 and 2002-324679, WO 02/15645, Tokkai 2002-332291, 2002-50484, 2002-332292 and 2002-83684, Tokuhyou 2002-540572, Tokkai 2002-117978, 2002-338588, 2002-170684 and 2002-352960, WO 01/93642, 2002-50483, 2002-100476, 2002-173674, 2002-359082, 2002-175884, 2002-363552, 2002-184582 and 2003-7469, Tokuhyou 2002-525808, Tokkai 2003-7471, Tokuhyou 2002-525833, and Tokkai 2003-31366, 2002-226495, 2002-234894, 2002-235076, 2002-241751, 2001-319779, 2001-319780, 2002-62824, 2002-100474, 2002-203679, 2002-343572 and 2002-203678

A part of examples is shown below.

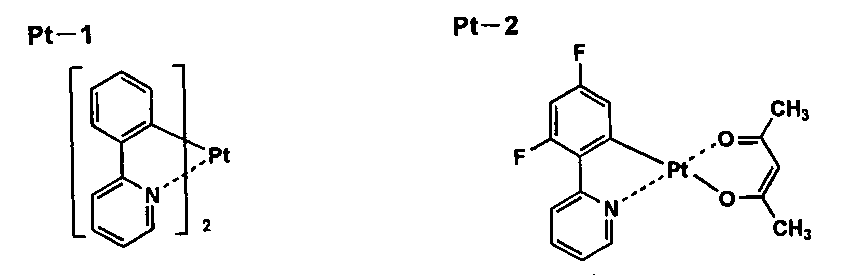

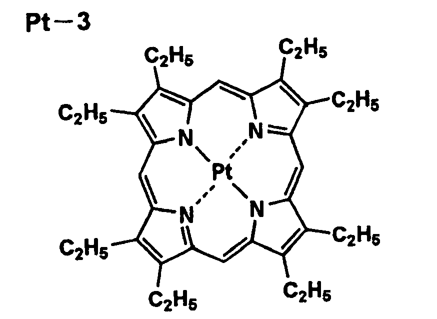

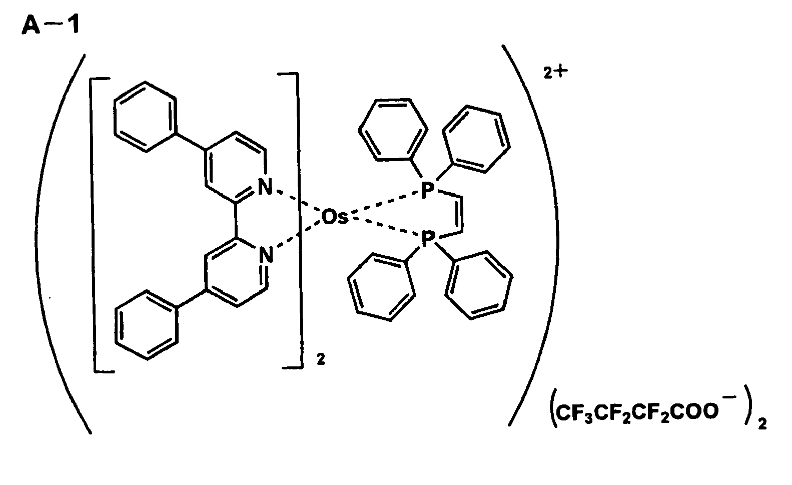

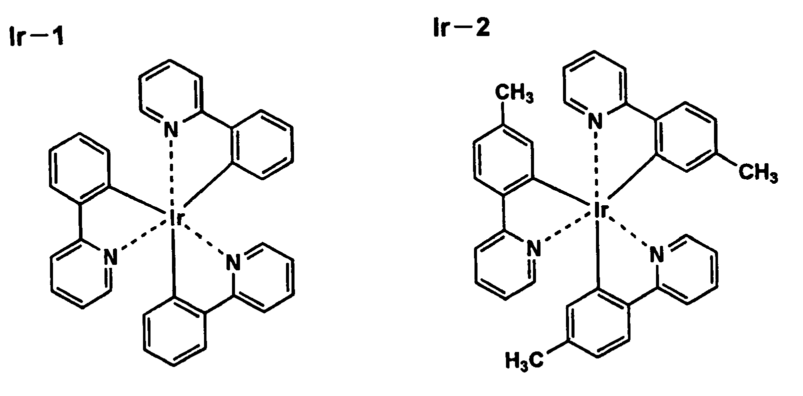

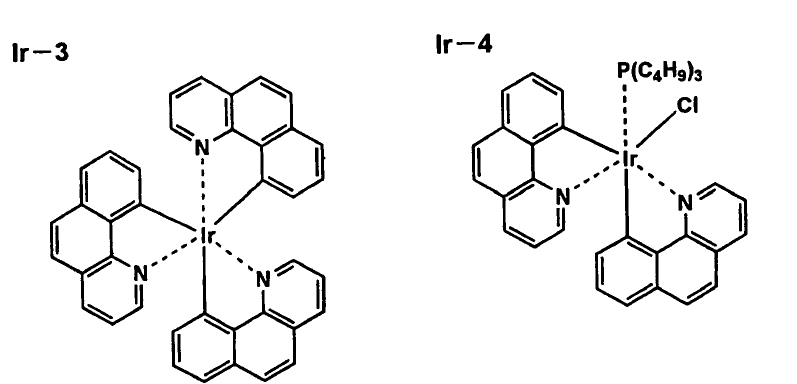

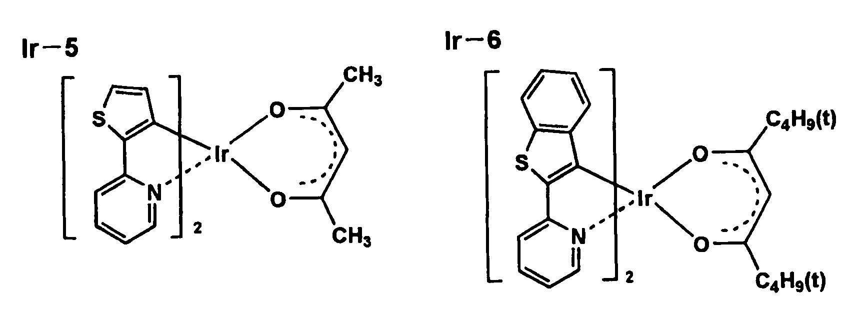

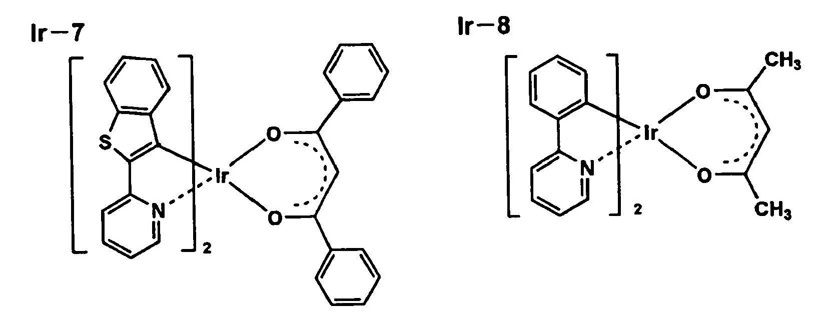

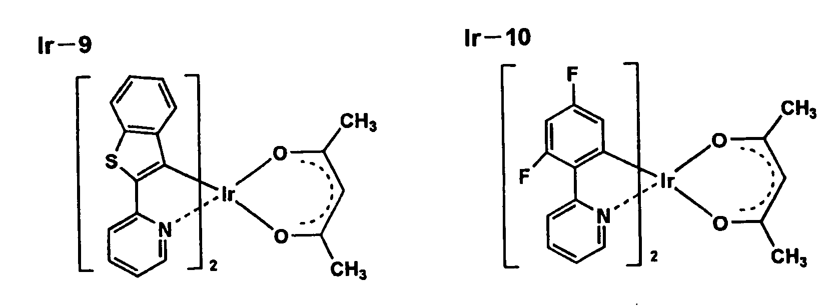

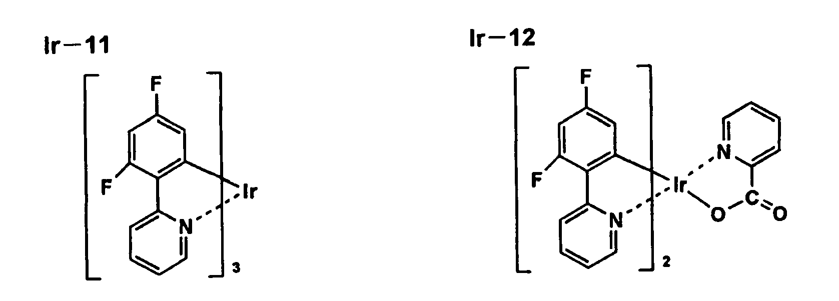

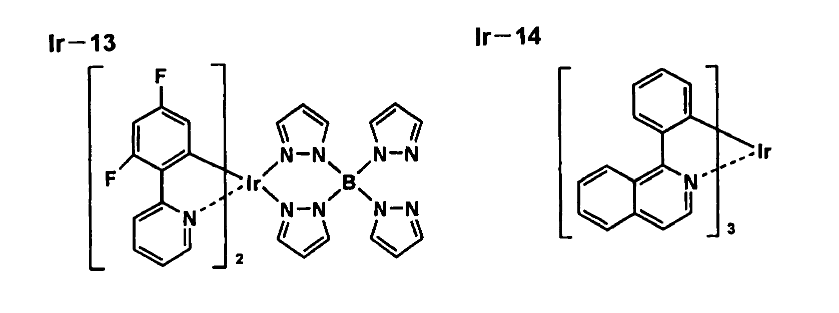

As the light emission dopant, plural kinds of the compounds may be used in a mixture.

### (Light emission host)

The light emission host, referred to as simply the host, is a compound contained in the largest amount in the light emission layer comprising two or more compounds and the other compound is referred to as the dopant compound or simply the dopant. For example, when the light emission layer is constituted by compounds A and B in a mixing ratio A:B is 10:90, the compound A is the dopant compound and the compound B is the host compound. When the light emission layer is constituted by three kinds of compounds A, B and C in a mixing ratio of 5:10:85, the compounds A and B are the dopant compound and the compound C is the host compound.

The structure of the light emission host is not specifically limited though ones having a basic structure of carbazole derivative, aromatic borane derivative, nitrogen-containing heterocyclic compound, thiophene derivative, furan derivative and oligoarylene compounds, and carboline derivatives and diazacarbazole derivative (the diazacarbazole compound is ones in which at least one of carbon atoms of the hydrocarbon rings constituting the carboline ring of the carboline derivatives is substituted by a nitrogen atom) can be typically cited.

Among them, the carboline derivatives and diazacarbazole derivatives are preferably used.

Concrete examples of the carboline derivatives and diazacarbazole derivatives are shown below but the invention is not limited to them.

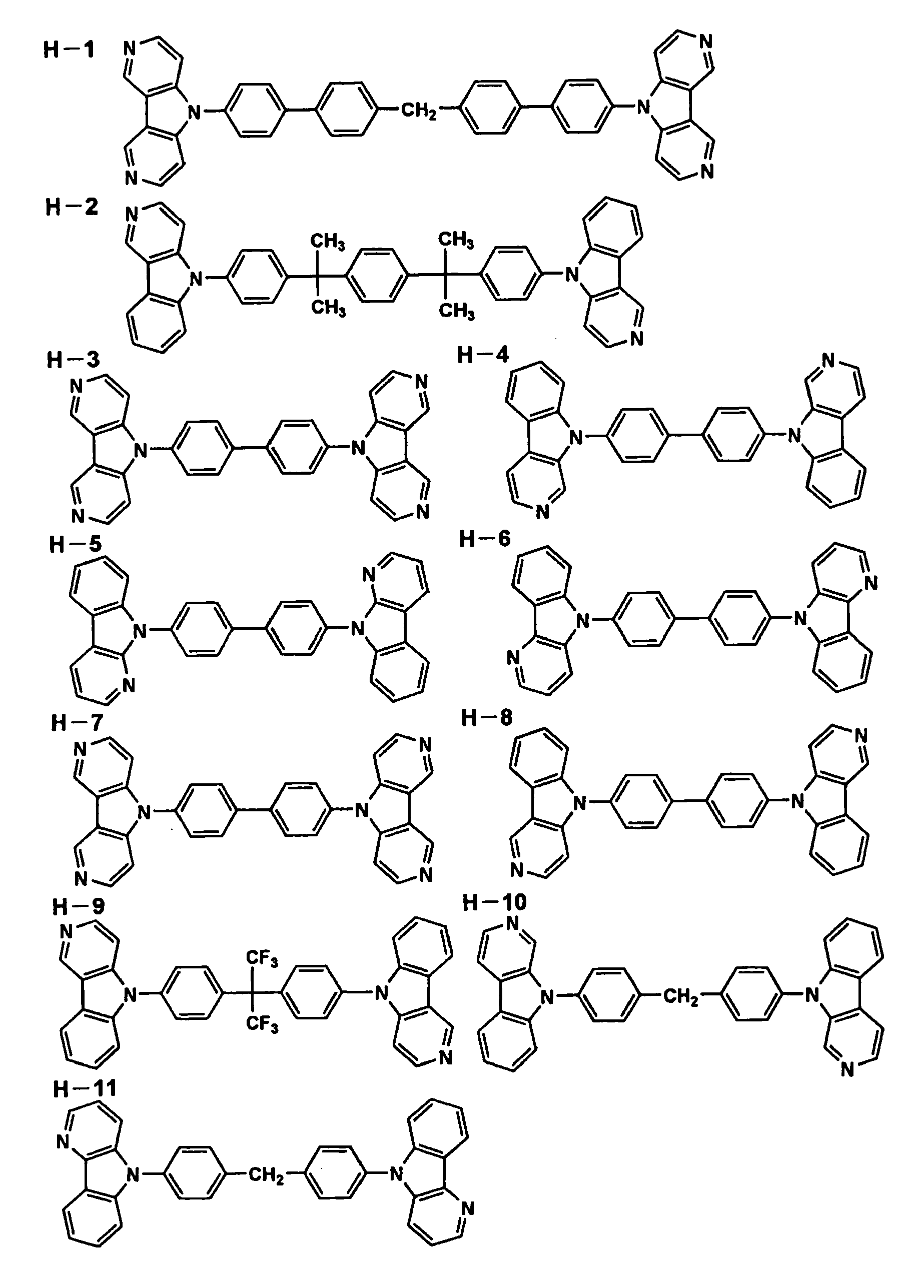

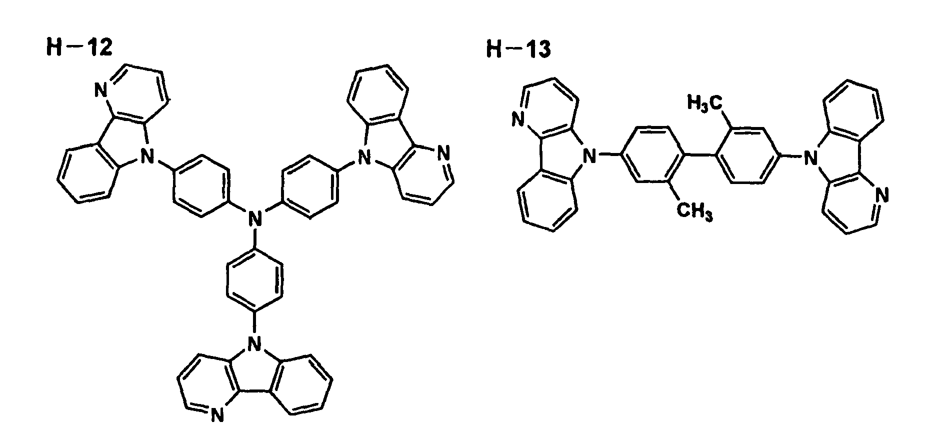

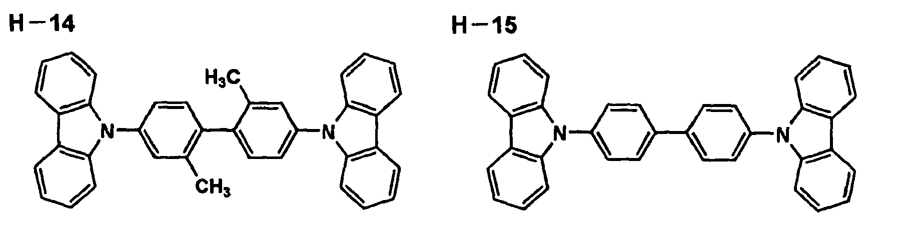

The phosphoresce host to be used in the invention may be a low molecular weight compound, a polymer compound having a repeating unit or a low molecular weight compound having a polymerizable group such as a vinyl group and an epoxy group (vapor deposition polymerizable light emission host).

As the light emission host, compounds which have the positive hole transfer ability and electron transfer ability and prevents shift of the wavelength of emitted light to longer side and is high in the Tg (glass transition temperature) are preferred.

As the concrete examples, the compounds described in the following publications are suitable; for example, Tokkai 2001-257076, 2002-308855, 2001-313179, 2002-319491, 2001-357977, 2002-334786, 2002-8860, 2002-334787, 2002-15871, 2002-334788, 2002-43056, 2002-334789, 2002-75645, 2002-338579, 2002-105445, 2002-343568, 2002-141173, 2002-352957, 2002-203683, 2002-363227, 2002-231453, 2003-3165, 2002-234888, 2003-27048, 2002-255934, 2002-260861, 2002-280183, 2002-299060, 2002-302516, 2002-305083, 2002-305084 and 2002-308837.

Plural kinds of known host compound may be used together with. Moreover, different emitted lights can be mixed by using plural kinds of the dopant compound. Thus color of emitted light can be arbitrarily obtained. White light can be emitted by controlling the kind and doping amount of the phosphoresce compound, and such the light can be utilized for illumination and backlight.

The color of light emitted from the organic EL device of the invention is defined by the color obtained by applying the results of measuring by a spectral emission luminance meter CS-1000, manufactured by Konica Minolta Sensing Inc., to CIE coordinate according to Fig. 4.16 on page 108 of "New Edition Color Science Handbook", edited by The Nihon Color Science Association, University of Tokyo Press, 1985.

The light emission layer can be formed by making the above compound to thin layer by a known thin layer forming method such as a vacuum deposition method, spin coat method, casting method, LB method and ink-jet method. The thickness of the light emission layer is usually selected within the range from 5 nm to 5 µm, and preferably from 5 to 200 nm though the thickness is not specifically limited. The light emission layer may have a mono-layer structure comprising the host compound and one or more kinds of the phosphoresce compound or a multi-layer structure composed of plural layers the same of different in the composition thereof.

### (Positive hole transfer layer)

The positive hole transfer layer comprises a positive hole transfer material having a positive hole transfer ability and the positive hole injection layer and electron blocking layer are included in the positive hole transfer layer in wide means. The positive hole transfer layer can be provided singly or plurally.

The positive hole transfer material is a material having one of an ability of injecting or transferring of positive hole and a ability of electron blocking, and may be an organic or inorganic substance. As examples of that, triazole derivatives, oxadiazole derivatives, imidazole derivatives, polyarylalkane derivatives, pyrazoline derivatives, pyrazolone derivatives, phenylenediamine derivatives, arylamine derivatives, amino acid-substituted chalcone derivatives, oxazole derivatives, styrylanthrathene derivatives, fluorenone derivatives, hydrazone derivatives, stilbene derivatives, silazane derivatives, aniline type polymers, electroconductive oligomers and particularly thiophene oligomers are cited.

The above-described materials can be used as the positive hole transfer material though porphylin compounds, aromatic tertiary amine compounds and styrylamine compounds, particularly aromatic tertiary amine compounds are preferably used.

Typical examples of the aromatic tertiary amine compound and the styrylamine compound include N,N,N',N'-tetraphenyl-4,4'-diaminophenyl; N,N'-diphenyl-N,N'-bis(3-methylphenyl)-[1,1'-biphenyl]-4,4'-diamine (TPD); 2,2-bis(4-dip-triaminophenyl)propane; 1,1'-bis(4-di-p-triaminophenyl)-cyclohexane; N,N,N',N'-tetra-p-tolyl-4,4'-diaminobiphenyl; 1,1-bis(4-di-p-tolylaminophenyl)-4-phenylcyclohexane; bis(4-dimethylamino-2-methylphenyl)phenylmethane; bis(4-di-p-tolylaminophenyl)phenylmethane; N,N'-diphenyl-N,N'-di(4-methoxyphenyl)-4,4'-diaminobiphenyl; N,N,N',N'-Tetraphenyl-4,4'-diaminodiphenyl ether; 4,4'-bis(diphenylamino)-quadryphenyl; N,N,N-tri(p-tolyl)amine; 4-(di-p-tolylamino)-4'-[4-(di-p-tolylamino)styryl]stilbene; 4-N,N-diphenylamino-(2-diphenylvinyl)benzene; 3-methoxy-4'-N,N-dihenylaminostilbenzene; N-phneylcarbazole; ones having two condensed aromatic rings in the molecule described in U.S.P. No. 5,061,569 such as 4,4'-bis[N-(1-naphthyl)-N-phenylamino]biphenyl (NPD); and ones in which triphenylamine units are linked in three starburst form described in Tokkai Hei 4-308688 such as 4,4',4"-tris[N-(3-methylphenyl)-N-phenylamino]triphenylamine. Polymer materials in each of which the above substance is introduced into the principal chain or having the above substance as the principal chain can be also used. Moreover, inorganic compounds such as p-Si and p-SiC are also usable.

The positive hole transfer layer can be formed by making the above positive hole transfer material into a thin layer by a known method such as a vacuum deposition method, a spin coat method, a casting method, a printing method including an ink-jet method and a LB method. The thickness of the positive hole transfer layer is usually from about 5 nm to 5 µm and preferably from 5 to 200 nm though there is no specific limitation. The positive hole transfer layer may be a single layer comprising one or more kinds of the above materials.

A positive hole transfer layer with high p-behavior doped by an impurity is also usable. As examples of such the material, ones described in Tokkai Hei 4-297076, Tokkai 2000-196140, 2001-102175 and J. Appl. Phys. 95, 5773 (2004) are cited.

### (Electron transfer layer)

When the electron transfer layer is single or plural layers, the electron transfer material (also functioning as the positive hole blocking material) to be used in the electron transfer layer adjacent to the cathode side is may be one having ability of transferring the electron injected from the cathode, and the material can be arbitrarily selected from known materials such as nitro-substituted fluorene derivatives, diphenylquinone derivatives, thiopyrane dixoide derivatives, carbodimide, fluorenylidenemethane derivatives, anthraquinodimethane and anthrone derivatives and oxadiazole derivatives. Moreover, thiadiazole derivatives formed by substituting the oxygen atom in the above oxadiazole derivatives by an sulfur atom and quinoquizaline derivatives having a quinoquizaline ring known as electron-attractive group are also usable as the electron transfer material. Polymer materials in each of which the above substance is introduced into the principal chain or having the above substance as the principal chain can be also used.

Furthermore, metal complexes of 8-quinolinol such as tris(8-quinolinol) aluminum (Alq), tris(5,7-dichloro-8-quinolinol) aluminum, tris(5,7-dibromo-8-quinolinol) aluminum, tris(2-methyl-8-quinolinol) aluminum, tris(5-methyl-8-quinolinol) aluminum, bis(8-quinolinol) zinc (Znq), and metal complexes formed by replacing the central metal atom by In, Mg, Cu, Ca, Sn, Ga or Pb are also usable as the electron transfer material. Moreover, metal free- or metal-phthalocyanine and their derivative substituted by an alkyl group or a sulfonic acid group at the terminal thereof are preferably used as the electron transfer material. Distyrylpyrane derivatives exemplified as the material of the light emission layer can be used as the electron transfer layer and inorganic compounds such as n-Si and n-SiC similarly in the positive hole transfer layer and the positive hole transfer material.

The electron transfer layer can be formed by making the above electron transfer material into a thin layer by a known method such as a vacuum deposition method, a spin coat method, a casting method, a printing method including an ink-jet method and a LB method. The thickness of the electron transfer layer is usually from about 5 nm to 5 µm and preferably from 5 to 200 nm though there is no specific limitation. The electron transfer layer may be a single layer comprising one or more kinds of the above materials.

An electron transfer layer with high n-behavior doped by an impurity is also usable. As examples of such the material, ones described in Tokkai Hei 4-297076, Tokkai 2000-196140, 2001-102175 and J. Appl. Phys. 95, 5773 (2004) are cited.

In the organic El device of the invention, the exterior taking out efficiency of light at room temperature is preferably not less than 1% and more preferably not less than 5%. The exterior output efficiency is as follows:

Light extraction efficiency (%) = Number of photon emitted to outside/Number of electron flowed through organic EL device x 100.

A tone improving filter such as a color filter or a color conversion filter for conversing the color of light emitted form the organic EL device to another color by using a fluorescent substance may be used together with the organic EL device of the invention. When the color conversion filter is used, the λₘₐₓ of the emitted light of the organic EL device is preferably not more than 480 nm.

### (Productioon method of organic EL device)

The production method of organic EL device is described in detail below.

The production method of the organic EL device having the following structure is described as an example of the organic EL device; Anode/Positive hole injection layer/positive hole transfer layer/Light emission layer/electron transfer layer/Electron injection layer/Cathode.

A thin layer composed of a desired electrode material such as the anode material having a thickness of not more than 1 µm, preferably from 10 to 200 nm is formed on the substrate (the gas barrier film of the invention) by the vapor deposition method, sputtering method or the foregoing plasma CVD method to form an anode. Then the materials of organic EL device such as the organic compound thin layers of the positive hole injection layer, positive hole transfer layer, light emission layer, electron transfer layer, electron injection layer and positive hole blocking layer are formed on the anode.

As the method for forming these organic compound thin layers, the vapor deposition, wet process such as spin coat, casting, ink-jetting and printing methods are applicable, and the vapor deposition method, spin coat method, ink-jet method and printing method are preferable from the viewpoint of that a uniform layer easily can be obtained and a pin hole is difficultly formed. Different methods may be applied for each of the layers. When the vapor deposition method is applied, the deposition conditions are optionally selected from the range of a boat heating temperature of from 50 to 450 °C, vacuum degree of from 1 x 10⁻⁶ to 1 x 10⁻² Pa, a deposition rate of from 0.01 to 50 nm/sec a temperature of substrate from -5 to 300 °C and a layer thickness of from 0.1 nm to 5 µm, and preferably from 5 to 200 nm though the conditions is varied depending on the kind of the compound to be used.

After the formation of these layers, a thin layer composed of the cathode material is formed so that the layer thickness is within the range of not more than 1 µm, preferably from 50 to 200 nm, by the method such as vapor deposition and sputtering to provide a cathode. Thus desired organic EL device can be obtained. The production of the organic EL device is preferably continuously carried out from the formation of the positive hole injection layer to the cathode at once vacuum formation though it is arrowed that the substrate is taken out in the course of the production for applying a different layer forming method. In such the case, it should be consider that the operation is performed under an atmosphere of inert gas.

The order of the processing can be reversed so as to be in the order of the cathode, electron injection layer, electron transfer layer, light emission layer, positive hole transfer layer, positive hole injection layer and anode light emission can be observed when direct current of from about 2 to 40 V is applied to thus obtained multi-color display so that the positive polar of the current is applied to the anode and negative polar of the current is applied to cathode. An alternative current may also be applied. The wave shape of the alternative current to be applied may be arbitrarily selected.

The displaying apparatus using the organic EL devices can be used as a displaying device, display, various lighting light sources. Full color displaying can be realized by using three kinds of organic EL devices each emitting blue, red and green light, respectively.

As the displaying device and display, televisions, personal computers, mobile devices, AV instruments, letter broadcasting, information displaying in car are cited. The display may be used for displaying apparatus for reproducing still or moving images. When the display is used for reproducing the moving images, the driving system may be a simple matrix (passive matrix) system or an active matrix system.

The lighting implement using the organic EL device of the invention is applied as the light source of domestic lighting, car room lighting, back light of clocks and liquid crystal displays, advertisement signboards, signals, photo memory media, electrophotographic copiers, photo communication processors and photo sensors, but the use is not limited to the above.

The organic EL device of the invention may be used as an organic EL device having a resonator structure. The organic EL device with the resonator structure is usable as a light source of photo memory media, electrophotographic copiers, photo communication processors and photo sensors by the use is not limited to them. Laser light oscillated by the organic EL device may be used for the above uses.

The gas barrier film prepared by providing the ceramic layer having the remaining stress within the designated range on the resin film with high gas barrier ability according to the invention is a gas barrier film which is excellent in the production efficiency because formation of plural laminated ceramic layers is not necessary and the surface of which is easily processed to form unevenness for refracting or diffusing light.

### (Displaying apparatus)

The organic EL device of the invention may be used as a kind of lamp such as light source for lighting or exposing, or a projection apparatus for projecting images and a display for displaying still or moving images. When the device is used as the display for moving images, the driving system may be a simple matrix (passive matrix) system or an active matrix system. A full-color displaying apparatus can be produced by using three or more kinds of the organic EL device of the invention. The full-color display can be prepared by using a monotone light such as white light emission device and forming B, G and R light by using color filters. Moreover, full-color displaying can be realized by conversing color of the light emitted from the organic EL device to other color by using a color conversion filter. In such the case, the λₘₐₓ of the light emitted from the organic EL device is preferably not more than 480 nm.

An example of the displaying apparatus constituted by the organic EL device is described bellow according to the drawing.

Fig. 8 is a schematic drawing displaying an example of the displaying apparatus constituted by the organic EL devices. The drawing is a scheme of a display for displaying image information such as the display of a portable telephone.

Display 101 comprises a displaying part having plural pixels and a controlling part B for image scanning on the displaying part A according to image information.

The controlling part B is electrically connected with the displaying part A and transfers scanning signals and image data signals according to the image information from the exterior to the plural pixels so that the image information is displayed on the displaying part A and the pixels on each of the scanning lines successively emit light according to the scanning signals to display the image information on the displaying part A.

Fig. 9 is a schematic drawing of the displaying part A.

The displaying part A has wiring containing plural scanning lines 5 and data lines 106 and a plurality of pixels 103 provided on the substrate. The principal members of the displaying part A are described below. In Fig. 9, light emitted from the pixel 103 is taken out in the direction of the white arrow (downward).

The scanning line 105 and the plural data lines 106 are each composed of an electroconductive material and the scanning line 105 and the data line 106 are crossed at a right angle and connected to the pixel 103 at the crossing point (the detail is not shown in the drawing).

The pixel 103 receives image data signals from the data line 106 when the scanning signal is applied from the scanning line 105 and emits light according to the received image data. A full-color image can be displayed by suitably arranging pixels each emitting light in red region, green region and blue region side by side on the same substrate.

The light emission process of the pixel is described below.

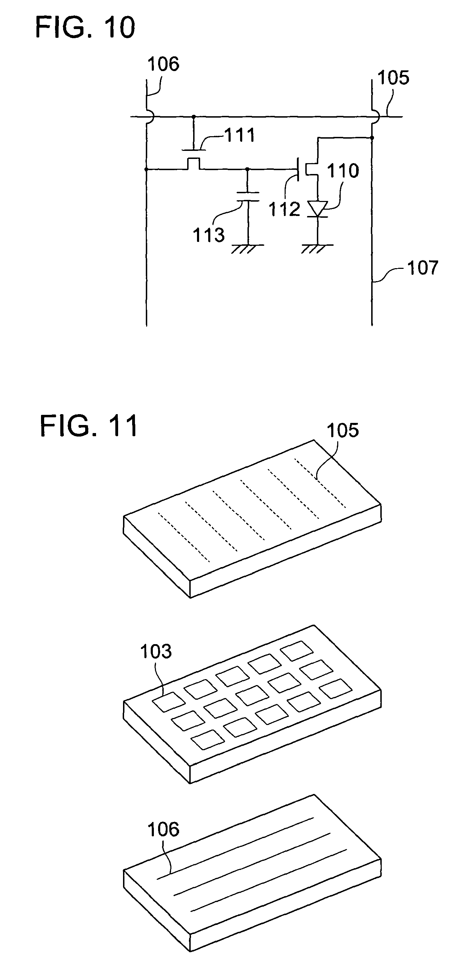

Fig. 10 is a scheme of the pixel.

The pixel has an organic EL device 110, a switching transistor 111, a driving transistor 112 and a condenser 113. Full-color image can be displayed by using the organic EL devices 110 each emitting red, green and blue light, respectively, as the plural pixels are arranged side by side on the same substrate.

In Fig. 10, the image data signals are applied to the drain of the switching transistor 111 from the controlling part B through the data line 106. When the scanning signal is applied to the gate of the switching transistor 111 through the scanning line 105 from the controlling part B, the switching transistor 111 is turned on and the image data signal applied to the drain is transferred to the condenser 113 and the gate of the driving transistor 112.

The condenser is charged corresponding to the potential of the data signal and the driving of the driving transistor 12 is turned on by the transferring of the image data signal. The driving transistor of the drain is connected to the power source line 107 and the source is connected to the electrode of the organic EL device, and electric current is supplied to the organic EL device 110 from the power source line 107 corresponding to the potential of the image data signal applied to the gate.

When the scanning signal is transferred to the next scanning line 105 by the successive scanning by the controlling part B, the driving of the switching transistor is turned off. However, the condenser 113 holds the potential of the image data signal charged therein so as to hold the driving of the driving transistor 112 when the driving of the switching transistor is turned off. Thus the light emission by the organic EL device 110 is continued until next scanning signal is applied. When the next scanning signal is applied by the successive scanning, the driving transistor 112 is driven according to the next image data signal synchronized with the scanning signal so that the organic EL device 110 emits light.

Namely, the switching transistor 111 and the driving transistor 112 are provided as an active element to each of the plural organic EL devices 110 to emit light from each of the organic EL device. Such the light emission system is called as the active matrix system.

The light emission of the organic EL device 110 may be the emission having plural gradation according to the multivalued image data having plural gradation potential or the ON/OFF emission of light of designated amount according to the binary image data.

The potential held by the condenser 113 may be held until the application of next scanning signal or discharged just before the application of the next scanning signal.

In the invention, the system is not limited to the foregoing active matrix system and a passive matrix system may be applied in which the organic EL device emits light corresponding to the signal only when the scanning signal is applied.

Fig. 11 is a scheme of the display by the passive matrix system. In Fig. 11, plural scanning lines 105 and plural image data lines 106 are lattice-wise provided so that the each lines are respectively opposite across the pixel 103.

The pixel 103 connected with the scanning line 105 emits light when the scanning signal is applied from the scanning line 105 by successive scanning. In the passive matrix system, the pixel has no active elements and the production cost can be reduced.

### (Lighting implement)

The organic EL material relating to the invention can be applied to a device for lighting implement emitting substantially white light. White light is obtained by mixing plural colors lights emitted by plural kinds of light emitting material. The combination of the plural colors may be one containing the maximum intensity wavelengths of the emitting light of the three primary colors, blue, green and red, or one containing two maximum intensity wavelengths of the emitting light having a complementary color relation such as blue and yellow or blue-green and orange.

The combination of the light emitting materials for obtaining the plural color lights may be one constituted by combining plural materials (dopants) emitting plural kinds of phosphorescence or fluorescence or one constituted by combining dye materials emitting light by excitation by the light emitted from the light emission materials, though the method by combination of plural light emitting dopants is preferable for the white light emitting organic EL device relating to the invention.

As the layer constitution of the organic EL device for obtaining the plural color lights, a method using the plural light emitting dopants contained in one light emission layer, a method using plural light emission layers each containing the dopant different in the wavelength of emitting light, respectively, and a method using fine pixels each different in the emitting light wavelength constituted into a matrix are cited.

In the white light emitting EL organic device relating to the invention, patterning may be applied according to necessity on the occasion of layer formation by a metal mask or ink-jet printing method. When patterning is applied, patterning may be applied only to the electrode or enter layers of the device.

The light emitting material to be used in the light emission layer is not specifically limited. For example, in the case of the backlight of liquid crystal display, the light can be made white by combining ones suitably selected from the platinum complex and know light so as to suite with the wavelength range corresponding to the property of the CF (color filter).

As above-described, the white light emitting organic EL device can be usefully used for various light emission sources, lighting implement such as domestic lighting and car room lighting, and as a kind of lamp such as an exposing light source and for the display such as the backlight of the liquid crystal display, additionally to the above-mentioned displaying device and display.

Other than the above, various wide uses such as a backlight of clock, advertising signboards, signals, a light source of photo memories, a light source of electrophotographic copiers, a light source of photo communication processors and usual domestic electric implement having display are cited.

### EXAMPLES

The invention is concretely described below referring examples. In the examples, "part" and "%" are each "parts by weight" and "percent by weight", respectively, as long as any specific description is not attached.

### <<Preparation of gas barrier film>>

### (Preparation of gas barrier film 1)

The following thin layers were formed by the atmospheric pressure plasma CVD method using the roller electrode type discharging treatment apparatus. In the roller electrode type discharging treatment apparatus, plural rod-shaped electrodes facing to the roller electrode are provided in parallel with the film conveying direction, and raw materials and electric power were supplied to the portion of each of the electrodes to form the thin layer.

On the both of the facing electrodes each of which is a metal mother member coated with a ceramic of a dielectric material by thermal spraying, the dielectric material was coated in a thickness of 1 mm. The space between the electrodes was set at 1 mm. The metal mother member coated with the dielectric material had a stainless steel jacket structure having a cooling function by cooling water and the discharging was carried out while controlling the electrode temperature by cooling water. The used power sources were a high frequency power source (80 kHz) manufactured by Oyo electric CO., Ltd., and a high frequency power source (13.56 MHz) manufactured by Pearl Kogyo Co., Ltd.

PEN film of 100 µm having an acryl type clear hard coat of 5 µm on both sides of which was provided was used as the resin film substrate, and a contacting layer, a ceramic layer and a protect layer were formed in this order on both sides of the above resin film substrate under the following conditions to prepare gas barrier film 1. The thickness of each of the layers was follows: Contacting layer: 50 nm Ceramic layer: 30 nm
Protect layer: 40 nm

The substrate holding temperature on the occasion of layer formation was 120 °C.

### <Ceramic layer>

Discharging gas: N₂ gas
Reacting gas 1: Oxygen gas in an amount of 5% of the entire gas
Reacting gas 2: Tetraethoxysilane (hereinafter referred to as TEOS) in an amount of 0.1% of the entire gas
Electric power of low frequency power source: 10 W/cm² at 80 kHz
Electric power of high frequency power source: 10 W/cm² at 13.56 MHz

### <Measurement of remaining stress>

The ceramic layer of 1 µm was formed on a quartz glass plate having a thickness of 100 µm, a width of 10 mm and a length of 50 mm and the remaining stress was measured by a thin layer property measuring apparatus MH4000 manufactured by NEC San'ei Co., Ltd. Thus measured remaining stress was 0.8 MPa.

### <Protection layer>

Discharging gas: N₂ gas
Reacting gas 1: hydrogen gas in an amount of 1% of the entire gas
Reacting gas 2: TEOS gas in an amount of 0.5% of the entire gas
Electric power of low frequency power source: 10 W/cm² at 80 kHz
Electric power of high frequency power source: 5 W/cm² at 13.56 MHz

### <Protect layer>

Discharging gas: N₂ gas
Reacting gas 1: hydrogen gas in an amount of 1% of the entire gas
Reacting gas 2: TEOS gas in an amount of 0.5% of the entire gas
Electric power of low frequency power source: 10 W/cm² at 80 kHz
Electric power of high frequency power source: 5 W/cm² at 13.56 MHz

### [Preparation of gas barrier film 2]

On the protect layer of the above gas barrier film 1, a coating liquid having the following composition was coated by a bar coater and dried for 5 minutes at 80 °C, and then cured with a high-pressure Hg lamp (80w) by irradiating UV of 400 mJ/cm² to prepare a gas barrier film 2. The thickness of the layer was controlled so as to be 100 nm after the curing.

### <Preparation of coating liquid>

| | |
|---|---|
| SiO₂ sol, Snowtex IPA-ST (Nissan Chemical Industries Ltd.) | 6 parts by weight |
| Trimethylolpropanetriglycidyl ether (active energy radiation reactive compound) | 1 part by weight |
| γ-glycidpropyltrimethoxysilane | 0.3 parts by weight |
| 4,4'-bis(di(β-hydroxyethoxy)phenylsulfonio)phenylsulfide-bis-hexafluoroantimonate (UV initiator) | 0.03 parts by weight |
| Cyclohexane | 600 parts by weight |
| Silicone oil SH200 (Dow Corning Toray Co., Ltd.) | 0.05 parts by weight |

### [Preparation of gas barrier film 3]

An organic polymer layer was formed as the coated layer on the protect layer of the above gas barrier film 1 by the following method to prepare a gas barrier film 3.

### <Organic polymer layer forming method>

The gas barrier film 1 was set in a vacuum deposition apparatus having a heating resistor terminal in which a high pressure mercury UV lamp was attached and the inner pressure of the apparatus was reduced by sucking by order of 1 x 10⁻⁴ Pa, and then heating by resistor the vapor source of organic material was begun to vapor deposit an organic layer of 100 nm. As the composition of the organic layer, 100 parts by weight of neopentyl glycol-modified trimethylolpropane diacrylate Kayarad R-604, manufactured by Nippon Kayaku Co., Ltd., added with 1 part by weight of a photopolymerization initiator Irgacure 651, manufactured by Ciba Specialty Chemicals, was used. After the deposition, the deposited layer was cured by irradiation of 500 mj/cm² of UV in total.

### [Preparation of gas barrier film 4]

An thermally polymerized inorganic polymer layer was formed as the coated layer on the protect layer of the above gas barrier film 1 by the following method to prepare a gas barrier film 4.

### <Preparation method of inorganic thermal polymerized layer>

Five parts by weight of zinc propoxide Zn(OPr)₂ was mixed with 1 part by weight of a mixed solvent composed of water, methanol, ethanol and isopropanol in a ratio of 1:1:1:4. Triethoxyboran B(OEt)₃ was added to the resultant mixture in a ratio of 0.2 moles/kg and dissolved by stirring for 10 minutes to prepare a reaction liquid 1. A reaction liquid 2 was prepared using acidic ammonium fluoride NH₄F·HF as halogen ion source and the mixed solvent the same as that used in the reaction liquid 1 so that the F⁻ ion concentration to the total weight of the liquid was 0.1 mole/kg. Thus prepared reaction liquids 1 and 2 were mixed in a ratio of 3:1 and stirred for 10 minutes. Then pH of the mixture was adjusted to 5.0 by using hydrochloric acid and ammonia water (an ethanol solution of methyl red and bromocresol green was used as an indicator), and the mixture was ripened for 3 hours for hydrolysis and dehydration condensation to prepare a coating liquid. The concentration of SiO₂ in the coating liquid was 10% and the carbon content was 40%.

Thus obtained coating liquid was coated on the protect layer of the gas barrier film 1 and thermally cured to form a thin layer of 100 nm. The heating was carried out at 150 °C for 3 hours.

### [Preparation of gas barrier film 5]

A gas barrier film 5 was prepared in the same manner as in the gas barrier film 2 except that the production method of the ceramic layer was changed as follows.

### «Formation of ceramic layer»

A ceramic layer was formed by a plasma CVD apparatus Model PD-270STP, manufactured by SAMCO Inc., under the following conditions.
Oxygen pressure: 39.9 Pa
Reaction gas: TEOS 5 sccm (standard cubic centimeter per minute)
Electric power: 100 W at 13.56 MHz
Substrate holding temperature: 120 °C
The remaining stress in the ceramic layer of the gas barrier film 5 measured by the same method as in the gas barrier film 1 was 80 MPa.

### <<Preparation of transparent electrode layer>>

A transparent electrode layer (ITO layer) was formed by the following method on each of the above prepared gas barrier films.

### <Formation of transparent electrode layer»

A plasma discharging apparatus having parallel flat plate type electrodes was used and each of the above gas barrier films was placed between the electrodes and a mixed gas was introduced for forming a thin layer.

The grounded electrode was prepared as follows: A stainless steel plate of 200 mm x 200 mm x 2 mm was covered by a high density and adhesive alumina sputtering layer and coated with a solution prepared by diluting teramethoxysilane by ethyl acetate and dried. And then the coated layer was cured by UV irradiation and subjected to sealing treatment. Thus obtained surface of the dielectric substance covering layer was polished for smoothing so that the maximum surface roughness Rₘₐₓ was made to 5 µm. Thus prepared electrode was used. The electric power applying electrode which is composed of a square columnar hollow pure titanium pipe covered by the dielectric material in the same manner as in the grounding electrode was used. Plural electric power applying electrodes were prepared and faced to the grounding electrode to form a discharging space.

As the electric source for generating plasma, an electric power of 5 W/cm² at 13.56 MHz by the high frequency power source CF-5000-13M, manufactured by Pearl Industry Co., Ltd.

A mixed gas having the following composition was flowed between the electrodes to make the plasma state for plasma treating the each of the above gas barrier films so as to form a tin-doped indium oxide (ITO) layer of 100 nm onto the protect or coated layer.
Discharging gas: Helium, 98.5% by volume
Reactive gas 1: Oxygen, 0.25% by volume
Reactive gas 2: indium acetylacetonate, 1.2% by volume
Reactive gas 3: Dibutyl tin acetate, 0.05% by volume «Preparation of organic EL device»

Each of the gas barrier films of 100 mm x 100 mm on which the ITO layer was formed was subjected to patterning and washed by isopropyl alcohol while applying ultrasonic waves and dried by nitrogen gas. Thus obtained transparent base was fixed on a substrate holder of a vacuum deposition apparatus available on the market. On the other hand, 200 mg of α-NPD, 200 mg of CBP as the host compound, 200 mg of basocupron, 100 mg of Ir-1 and 200 mg of Alq₃ were each separately put into molybdenum resistor heating boats, respectively, and the boats were set in the vacuum deposition apparatus.

Then the pressure in the vacuum chamber was reduced by 4 x 10⁻⁴ Pa and the heating boat containing α-NPD was heated by applying electric current for vapor depositing the α-NPD onto the transparent base at a depositing rate of 0.1 nm/sec to form a positive hole transfer layer. Moreover, the heating boats each containing CBP and Ir-1 were heated by applying electric current so that the CBP and Ir-1 were vapor co-deposited onto the positive hole transfer layer at a deposition rate of 0.2 nm/sec and 0.012 nm/sec, respectively, to form a light emission layer. The temperature of the substrate on the occasion of the vacuum deposition was room temperature. After that, the heating boat containing BCP was heated by applying electric current for vapor depositing a positive hole blocking layer of 10 nm on the light emission layer at a depositing rate of 0.1 nm/sec. Then the heating boat containing Alq₃ was heated by applying electric current for vapor depositing the Alq₃ on the positive hole blocking layer at a deposition rate of 0.1 nm/sec to form an electron transfer layer having a thickness of 40 nm. The temperature of the substrate on the occasion of the vacuum deposition was room temperature.

Thereafter, a cathode was formed by vapor depositing lithium fluoride and aluminum each a thickness of 0.5 nm and 110 nm, respectively. Thus organic EL devices were obtained.

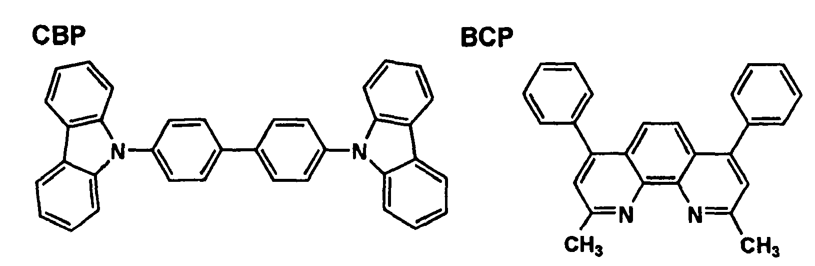

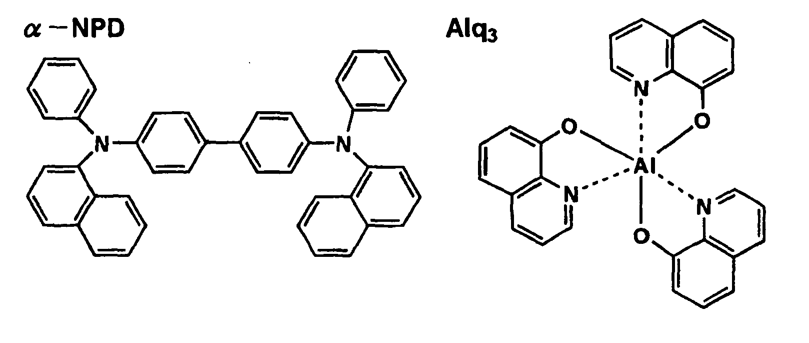

### <<Preparation of sealing film>>

On one side of aluminum foil of 30 µm, a layer of polypropylene of 30 µm was laminated. On the other side was subjected to a plasma discharging treatment using the roller electrode type discharging treatment apparatus shown in Fig. 3 the same as that used for forming the ceramic layer to form a ceramic (SiO₂) layer of 30 nm under the following conditions to prepare a sealing film.

### <Ceramic layer>

Discharging gas: N₂ gas
Reactive gas 1: Oxygen gas, 5% of the entire gas
Reactive gas 2: Tetraetoxysilane (TEOS), 0.1% of the entire gas.
Electric power of lower frequency power source: 10 W/cm² at 80 kHz
Electric power of higher frequency power source: 10 W/cm² at 13.56 MHz

The SiO₂ deposited surface of the sealing film was pasted with the cathode surface of the organic EL device and the circumference portion of the gas barrier film, where the organic EL element was not formed, by an epoxy type adhesive in an environment purged by nitrogen (inert) gas to seal the organic EL device. Thus organic EL devices 1 to 4 were prepared (Fig. 7a).

### <<Evaluation of gas barrier film>>

The water vapor permeability, center-line average roughness and maximum height of the above prepared gas barrier films 1 to 4 were measured.

### (Measurement of water vapor permeability)

The water vapor permeability (g/(m²·24h)) was measured at 25 ± 0.5 °C and 90 ± 2% RH by the method according to JIS K 7129-1992.

### (Measurement of oxygen permeability)

The oxygen permeability was measured by the method according to JIS K 7126B.

### (Measurement of center-line average roughness Ra and maximum height Rₘₐₓ)

The center-line average roughness Ra at a standard length of 2.5 mm and a cut off value of 0.8 mm and the maximum height Rₘₐₓ each described in JIS B 0601 were measured by a non-contact three dimensional fine surface appearance measuring system WYKO manufactured by Veeco Instruments Inc.

### <<Evaluation of organic EL device>>

Each of the above prepared organic EL devices was driven and the anti-dark spot ability and the lifetime of light emission were measured by the following methods.

### (Anti-dark spot ability)

Each of the above prepared organic EL devices was stored for 500 hours under a high humid and high temperature condition of 60 °C and 95% RH and then photographed in a enlarging ratio of 50 times for observing the occurrence of dark spots.

### (Light emission life time)

Each of the above prepared organic EL devices was continuously lighted by a constant current of 2.5 mA/cm² and a time (τ^{1/2}) until the luminance became a half of the initial value was measured as an indicator expressing the light emission lifetime.

Thus obtained results are shown in Table 1.

**Table 1**

| Gas barrier film No. | Organic EL device No. | Gas barrier film | | | | Organic EL device | | Remarks |
|---|---|---|---|---|---|---|---|---|
| | | Water vapor permeability (g/m²·24hr) | Oxygen permeability (g/m²·24hr) | Centerline average roughness (nm) | Maximum height (nm) | Anti-dark spot ability | Light emission lifetime (hr) | |
| 1 | 1 | 1 x 10⁻⁵ | <0.005 | 1.5 | 23 | Frequent occurrence | >10000 | Comparative |
| 2 | 2 | 1 x 10⁻⁵ | <0.005 | 0.6 | 7 | No occurrence | >10000 | Inventive |
| 3 | 3 | 1 x 10⁻⁵ | <0.005 | 0.6 | 7 | No occurrence | 57 | Comparative |
| 4 | 4 | 1 x 10⁻⁵ | <0.005 | 1.0 | 10 | No occurrence | 9600 | Inventive |
| 5 | 5 | 1 x 10⁻⁴ | <0.005 | 0.60 | 7 | Occurrence | 48 | Comparative |

As is cleared form Table 1, in the organic EL devices using the gas barrier film coated with the inorganic polymerizable compound, dark spots are not caused and the life time is long compared with the comparative examples.

## Claims

1. A gas barrier film comprising a resin film, a ceramic layer and a coated layer formed by coating a coating liquid containing a polymerizable inorganic compound each provided on the resin film in this order and the remaining stress in the ceramic layer is within the of from 0.01 MPa to 20 MPa.

2. The gas barrier film described in Claim 1, wherein the coated layer is placed at the outermost position.

3. The gas barrier film described in Claim 1 or 2, wherein the substance constituting the ceramic layer is one selected from the group consisting of silicon oxide, silicon oxide nitride, silicon nitride, aluminum oxide and a mixture thereof.

4. The gas barrier film described in any one of Claims 1 to 3, wherein the polymerizable inorganic compound is silica sol or alumina sol.

5. The gas barrier film described in any one of Claims 1 to 4, wherein the smoothness of the surface of the coated layer is not more than 1 nm in center-average roughness.

6. A resin base for an organic electroluminescence comprising a transparent electrode formed on the gas barrier film described in any one of Claims 1 to 5.

7. An organic electroluminescent device wherein a phosphorescent light emitting electroluminescent material and a metal layer to be a cathode are coated on the resin base for organic electroluminescence described in Claim 6 and a resin-laminated metal foil is further pasted thereon for sealing.

8. The organic electroluminescent device described in Claim 7, wherein the resin laminated metal foil is a metal foil laminated by a resin on the side not to be contacted with the cathode and coated by a ceramic layer on the side to be contacted with the cathode.

9. A method for producing the gas barrier film comprising a resin film and a ceramic layer and a coated layer each provided on the resin film in this order, wherein the ceramic layer is formed by a thin layer forming method in which gas containing a thin layer forming gas is supplied into an electric discharging space under atmospheric or near atmospheric pressure, and high frequency electric field is applied to the electric discharging space for exiting the gas, and then the substrate is exposed to the excited gas; and the coated layer is formed by coating a coating liquid containing an inorganic polymerizable compound.

10. The method for producing the gas barrier film described in Claim 9, wherein the water vapor permeability of the gas barrier film measured at 25 ± 0.5 °C and 90 ± 2% RH according to JIS K 7129-1992 is not more than 1 x 10⁻⁴ g/(m²·24h) and the oxygen permeability of that measured according to JIS K 7126-1987 is not more than 1 x 10⁻⁴ ml/( m²·24h·atm).

11. The method for producing the gas barrier film described in Claim 9 or 10, wherein the coated layer is placed at the outermost portion.

12. The method for producing the gas barrier film described in any one of Claims 9 to 11, wherein the remaining stress in the ceramic layer is within the range of from 0.01 MPa to 20 MPa.

13. The method for producing the gas barrier film described in any one of Claims 9 or 12, wherein the material constituting the ceramic layer is one selected from the group consisting of silicon oxide, silicon oxide nitride, silicon nitride, aluminum oxide and a mixture thereof.

14. The method for producing the gas barrier film described in any one of Claims 9 or 13, wherein the polymerizable inorganic compound is silica sol of alumina sol,

15. The method for producing the gas barrier film described in any one of Claims 9 or 14, wherein the surface roughness of the coated layer is not more than 1 nm in the center-line average roughness.
